(19) Europäisches Patentamt
European Patent Office
Office européen des brevets

(11) **EP 3 149 778 B1**

(12) **EUROPÄISCHE PATENTSCHRIFT**

(45) Veröffentlichungstag und Bekanntmachung des Hinweises auf die Patenterteilung:
**24.06.2020 Patentblatt 2020/26**

(21) Anmeldenummer: **15730057.5**

(22) Anmeldetag: **27.05.2015**

(51) Int Cl.:
*H01L 31/108* (2006.01)  *H01L 31/0352* (2006.01)
*H01L 31/0224* (2006.01)  *G02B 6/122* (2006.01)

(86) Internationale Anmeldenummer:
**PCT/EP2015/001088**

(87) Internationale Veröffentlichungsnummer:
**WO 2015/180841 (03.12.2015 Gazette 2015/48)**

(54) **PLASMONISCHES BAUTEIL UND PLASMONISCHER PHOTODETEKTOR SOWIE DEREN HERSTELLUNGSVERFAHREN**

PLASMONIC COMPONENT AND PLASMONIC PHOTODETECTOR AND METHOD FOR PRODUCING SAME

COMPOSANT PLASMONIQUE, PHOTODÉTECTEUR PLASMONIQUE ET LEUR PROCÉDÉ DE FABRICATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.05.2014 DE 102014007936**

(43) Veröffentlichungstag der Anmeldung:
**05.04.2017 Patentblatt 2017/14**

(73) Patentinhaber: **Karlsruher Institut für Technologie 76131 Karlsruhe (DE)**

(72) Erfinder:
• **MÜHLBRANDT, Sascha**
**75446 Wiernsheim (DE)**
• **LEUTHOLD, Jürg**
**CH-8173 Neerach (DE)**
• **KOHL, Manfred**
**76297 Stutensee (DE)**

(74) Vertreter: **Müller-Boré & Partner Patentanwälte PartG mbB Friedenheimer Brücke 21 80639 München (DE)**

(56) Entgegenhaltungen:
**US-A1- 2011 203 656    US-A1- 2012 280 345**

• **RALEY N F ET AL: "VERTICAL SILICON MEMBRANES FOR SUPER-SCHOTTKY DIODES", IEEE TRANSACTIONS ON MAGNETICS, IEEE SERVICE CENTER, NEW YORK, NY, US, Bd. MAG-19, Nr. 3, PART 01, Mai 1983 (1983-05), Seiten 507-511, XP000821708, ISSN: 0018-9464, DOI: 10.1109/TMAG.1983.1062375**
• **SOLIN S A ET AL: "Room Temperature Extraordinary Magnetoresistance of Nonmagnetic Narrow-Gap Semiconductor/Metal Composites: Application to Read-Head Sensors for Ultrahigh-Density Magnetic Recording", IEEE TRANSACTIONS ON MAGNETICS, IEEE SERVICE CENTER, NEW YORK, NY, US, Bd. 38, Nr. 1, Januar 2002 (2002-01), XP011034249, ISSN: 0018-9464**

**Beschreibung**

Die vorliegende Erfindung betrifft plasmonische Bauteile, insbesondere plasmonische Wellenleiter, sowie plasmonische Photodetektoren, welche auf dem Gebiet der Mikro- und Nanooptik eingesetzt werden können, insbesondere in der hochintegrierten optischen Kommunikationstechnik im Infrarotbereich (IR-Bereich) als auch in der Energietechnik, z.B. der Pholtovoltaik im sichtbaren Bereich. Zusätzlich gibt die vorliegende Erfindung ein Verfahren zur Herstellung eines plasmonischen Bauteils an, insbesondere zur Photodetektion auf Grundlage einer internen Photoemission.

Das Gebiet der integrierten Photonik, insbesondere die Integration von Photonik in die etablierte Silizium-Chip-Technologie ist seit einigen Jahren ein sehr aktives Forschungsgebiet und verspricht großen praktischen Nutzen in der Kombination und Fusion von elektronischer und optischer Datenübertragung und -verarbeitung. Nano-photonische Systeme mit hoher Komplexität und einer Vielzahl von Funktionen können so auf kleinsten Raum implementiert und industriell hergestellt werden. Hierbei spielen Wellenleiterstrukturen insbesondere zur optischen Verbindung integrierter photonischer Systeme untereinander (Chip-Chip-Verbindungen), sowie zur Verbindung innerhalb eines photonischen Systems (On-Chip Verbindungen) eine wichtige Rolle.

Allerdings stellen sich immer wieder die optischen Verbindungen zwischen einzelnen photonischen Systemen als eine wesentliche technologische Hürde bei der kommerziellen Umsetzung heraus. So werden sowohl an die Positioniergenauigkeit als auch an die Güte bzw. die optische Qualität solcher optischen Verbindungen Anforderungen gestellt, die sich in der Fertigung hoch-integrierter Schaltungen nur schwer erreichen lassen. Jedenfalls erfordern optische Verbindungen beispielsweise auf Basis herkömmlicher Glasfasern, welche direkt an den Chip gekoppelt werden, sehr viele Arbeitsschritte, die gar nicht oder nur schwer automatisierbar sind, und führen zu vergleichsweise geringen Integrationsdichten von Chip-Chip-Verbindungen. Dies wiederum führt zu hohen Produktions- und Stückkosten.

Die Technologie der optischen Verbindungen für integrierte photonische Systeme ist also von entscheidender Bedeutung für die Entwicklung photonischer Schaltkreise. Es gab hierzu in der Vergangenheit eine Reihe verschiedener Ansätze, die Herstellung photonischer Verbindungswellenleiter in integrierten photonischen Systemen zu verbessern. Insbesondere gab es verschiedene Ansätze, optische Verbindungen in integrierte Schaltkreise (ICs) auf Basis der CMOS-Technologie zu integrieren, welche auf unterschiedlichen physikalischen Effekten basieren. Hierzu zählt auch die Ausnutzung eines internen Photoemissionseffekts zur Photo- bzw. Lichtdetektion.

Als Photodetektoren werden im Allgemeinen elektronische Bauteile bezeichnet, die Licht aufgrund des photoelektrischen Effekts in ein elektrisches Signal umwandeln oder einen von der einfallenden Strahlung abhängigen elektrischen Widerstand zeigen. Die Funktionsweise basiert hierbei auf der Absorption von Licht in Form von Photonen und der anschließenden Auftrennung der durch Licht erzeugten Ladungsträger. Gewöhnliche Photodioden basieren auf dem Prinzip, dass durch die Absorption der Photonen Elektronen vom Valenzband in das energetisch höher gelegene Leitungsband gehoben werden, wofür die Energie des einzelnen Photons mindestens der Bandlücke des bestrahlten Halbleiters entsprechen muss. In diesem Fall der linearen Wechselwirkung bedarf es jedoch einer großen Detektionsfläche, um die Effizienz der Photodioden zu erhöhen. Daher erlauben konventionelle Photodioden, zum Beispiel auf Basis von Germanium, vergleichsweise geringe Integrationsdichten von Chip-Chip-Verbindungen.

In jüngster Zeit gab es verschiedene Ansätze die Nachteile gewöhnlicher Photodetektoren unter Ausnützung der internen Photoemission - dem Gebiet der Plasmone - zu überwinden.

Oberflächenplasmone sind elektromagnetische Oberflächenwellen, die kohärent an Ladungsträgerdichteschwankungen gekoppelt sind und an Grenzflächen eines Metalls zu einem Isolator/Halbleiter gebunden sind. Analog zum Photon, dem Quant einer Lichtwelle, bezeichnet das Plasmon das Quant einer durch ein Plasma laufenden Ladungsträgerdichtewelle. Im Sinne des Welle-Teilchen Dualismus wird als Plasmon jedoch nicht nur das Quant des Wellenfeldes, sondern auch die fortlaufende Ladungsträgerdichtewelle im Ganzen bezeichnet. Aufgrund ihres hybriden Charakters auf Basis von Elektronen und Photonen, können Oberflächenplasmone zur Übertragung von Informationen genützt werden, wobei die Vorteile in der geringen räumlichen Ausdehnung plasmonischer Bauelemente liegen. Die geringe Ausdehnung ermöglicht kleine Kapazitäten und somit kurze Reaktionszeiten auf äußere elektrische Felder. Oberflächenplasmone unterliegen nicht den Beugungsgrenzen der Wellenmechanik und zeichnen sich durch ein verstärktes elektromagnetisches Feld aus, wodurch eine verstärkte Wechselwirkung zwischen Licht und Materie, insbesondere in Form nichtlinearer Wechselwirkung, auftritt. Diese Nichtlinearität ist grundsätzlich vergleichbar mit der der Zwei-Photonen-Absorption, die eine quadratische Abhängigkeit von der Lichtintensität (Leistung) zeigt.

Das Plasmon an einer Metall-Halbleiter Grenzfläche zerfällt durch Absorption im Metall, wobei energiereiche Elektronen, sogenannte "heiße Elektronen", genau an der Grenzfläche zum Halbleiter erzeugt werden. Diese heißen Elektronen sind in der Lage, die Potentialbarriere zwischen Halbleiter und Metall zu überwinden, was zu einer lichtinduzierten Ladungstrennung und somit einem messbaren Strom führt. Dieser Prozess ist als interne Photoemission bekannt. Hierbei kann die Potentialbarriere entweder direkt oder auch in Form quantenmechanischer Tunneleffekte überwunden werden. Die Wahrscheinlichkeit, dass die Ladungsträger die Potentialbarriere überwinden, wird durch eine exponentielle Funktion der Barriereform, z.B. Breite und Höhe, sowie der Ladungsträgerenergie bestimmt.

Zur Ausnutzung der internen Photoemission zur Lichtdetektion wurden in der Vergangenheit verschiedene Metall-Halbleiter Geometrien vorgeschlagen. Beispielsweise wird von M. W. Knight et al., Science, Vol. 332 (6030), S. 702-704 (2011), die Photodetektion mit aktiven optischen Antennen beschrieben, wobei in Silizium eingebettete Nanoantennen in Form von rechteckigen Golddrähten verwendet werden. Darüber hinaus werden mit Metallen beschichtete photonische Wellenleiter, wie beispielsweise in M. Casalino et al., Optics Express, Vol. 21 (23), S. 28072-28082 (2013) oder in US2012/280345 A1 beschrieben, als Photodetektoren eingesetzt.

Diese Ansätze versuchten die nicht absorbierende Gegenelektrode möglichst weit entfernt von der absorbierenden Elektrode zu platzieren, um in der Gegenelektrode möglichst wenig Verlustleistung zu erzeugen. Damit verbunden sind jedoch lange Ladungsträgerdriftzeiten. Grundsätzliche Probleme dieser Ansätze waren geringe Quanteneffizienzen von unter einem Prozent im Falle von Nanoantennen aufgrund schlechter Ankopplung an die elektromagnetische Welle und eine geringe elektrische Bandbreite, die im Fall der vorstehend beschriebenen Wellenleitern im niedrigen GHz-Bereich von ungefähr 1 GHz liegt.

Der vorliegenden Erfindung liegt daher die Aufgabe zugrunde, ultrakompakte plasmonische Bauteile, insbesondere in Form von plasmonischen Wellenleitern, sowie plasmonische Photodetektoren mit einer erhöhten Quanteneffizienz und einer verbesserten elektrischen Bandbreite bereitzustellen, die eine im Vergleich zu konventionellen Photodioden höhere Integrationsdichte erlauben. Insbesondere ist die Aufgabe der vorliegenden Erfindung die Bereitstellung eines flexiblen Herstellungsprozesses für ein plasmonisches Bauteil mit unterschiedlichen Metallen und den vorstehend genannten Eigenschaften, ohne jedoch einen Kurzschluss zwischen den Metallen zu erzeugen, sowie für einen entsprechenden plasmonischen Photodetektor.

Der Gegenstand der Erfindung wird in dem Verfahrensanspruch 1, in dem Produktanspruch 7, sowie in den Verwendungsansprüchen 13-15 definiert.

Gemäß der vorliegenden Erfindung wird unter dem Begriff "plasmonisches Bauteil" ein Bauteil verstanden, mit welchem elektromagnetische Wellen im sichtbaren Bereich (Wellenlängen im Bereich von 380 nm bis 780 nm) oder infraroten Bereich (Wellenlängen zwischen 780 nm und 1 mm) des Spektrums in Form eines Oberflächenplasmons an der Grenzfläche eines Metall-Halbleiters geführt werden und aufgrund einer internen Photoemission zu einer lichtinduzierten Ladungstrennung und somit einem messbaren Strom führt.

In einer bevorzugten Ausführungsform der vorliegenden Erfindung liegt das plasmonische Bauteil in Form eines plasmonischen Wellenleiters vor. Vorzugsweise wird durch das erfindungsgemäße Verfahren ein plasmonischer Wellenleiter mit einem Metall-Halbleiter-Metall Kontakt (nachfolgend auch Metall-Halbleiter-Metall Wellenleiter genannt) hergestellt, bei welchem eine erste Elektrode in Form einer ersten Metallschicht von einer zweiten Elektrode in Form einer von der ersten Metallschicht verschiedenen Metallschicht durch eine Halbleiterschicht mit einer Dicke von weniger als 100 nm getrennt ist, wobei die erste Metallschicht nicht in direktem Kontakt mit der zweiten Metallschicht steht.

Das erfindungsgemäße Verfahren umfasst als ersten Schritt das Bereitstellen einer Halbleiterschicht auf einem Substrat, welches vorzugsweise in Form eines isolierenden Materials vorliegt. Insbesondere kann diese Halbleiterschicht in einem Bereich eines isolierenden Materials aufgebracht oder abgeschieden werden, in dem auch der Metall-Halbleiter-Metall Kontakt bzw. der Metall-Halbleiter-Metall Wellenleiter hergestellt werden soll. Als isolierendes Material können dem Fachmann bekannte Materialien verwendet werden.

Die Halbleiterschicht wird insbesondere in Form einer flächigen Beschichtung bereitgestellt. Erfindungsgemäß liegt die Halbleiterschicht in Form eines Festkörpers vor und schließt Elementhalbleiter und Verbindungshalbleiter ein. Geeignete Materialien sind dem Fachmann bekannt und können in Abhängigkeit vom gewünschten Einsatzzweck des erfindungsgemäßen Bauteils ausgewählt werden. Bevorzugte Elementhalbleiter bestehen aus Germanium, Silizium oder Zinn ($\alpha$-Zinn). Geeignete Verbindungshalbleiter umfassen chemische Verbindungen, die im Mittel vier Valenzelektronen besitzen, deren spezifischer Widerstand im Bereich von $10^{-4}$ $\Omega \cdot m$ bis $10^6$ $\Omega \cdot m$ liegt. Hierzu zählen Verbindungen von Elementen der 13. mit der 15. Hauptgruppe des Periodensystems der Elemente, wie beispielsweise Galliumarsenid (GaAs) oder Indiumantimonid (InSb), und der 12. Neben- mit der 16. Hauptgruppe, wie beispielsweise Zinkselenid (ZnSe) oder Cadmiumsulfid (CdS).

Gemäß einer bevorzugten Ausführungsform umfasst die Halbleiterschicht Germanium oder Silizium, wobei Silizium besonders bevorzugt ist. Insbesondere kann die Halbleiterschicht in Form einer Siliziumschicht bereitgestellt werden, welche auf einem isolierenden Material, wie beispielsweise Siliziumdioxid ($SiO_2$), aufgebracht oder abgeschieden ist.

Die Halbleiterschicht weist vorzugsweise eine Schichtdicke von circa 50 nm bis circa 2 $\mu m$, mehr bevorzugt von circa 100 nm bis circa 1 $\mu m$, und besonders bevorzugt von 200 nm bis 500 nm auf. In der vorliegenden Erfindung wird die Schichtdicke der Halbleiterschicht als senkrechte Ausdehnung der Halbleiterschicht in Bezug auf die Kontaktfläche zwischen Substrat und Halbleiterschicht verstanden, die auch als Höhe der Halbleiterschicht (Halbleiterschichthöhe) bezeichnet werden kann. Die Bestimmung der Schichtdicken kann beispielsweise über Ellipsometrie erfolgen. Die Schichtdicken lassen sich mit dieser Messmethode typischerweise auf wenige Nanometer genau bestimmen.

In einem weiteren Schritt wird mindestens teilweise auf einer der Oberflächen der Halbleiterschicht eine Oxidschicht bereitgestellt. Insbesondere wird diese Oxidschicht mindestens teilweise auf der dem Substrat gegenüberliegenden Oberfläche der Halbleiterschicht bereitgestellt. Dies kann durch im Stand der Technik bekannte Beschichtungsverfahren erfolgen, wobei vorzugsweise Halbleiter-Oxidschichten aufgebracht werden.

Erfindungsgemäß können in der Halbleitertechnik bekannte Beschichtungsverfahren verwendet werden, wobei einerseits die Bereitstellung der Oxidschicht durch Oxidation der Oberfläche der Halbleiterschicht erfolgen kann und andererseits durch Aufbringen einer separaten Halbleiter-Oxidschicht. Vorzugsweise erfolgt die Bereitstellung der Oxidschicht durch thermische Oxidation des Halbleitermetalls (im Falle eines Elementhalbleiters) oder der Halbleiterlegierung (im Falle eines Verbindungshalbleiters). Der Beschichtungsprozess basiert auf einer chemischen Reaktion von Sauerstoff mit dem Halbleiter, wobei die möglichen Beschichtungsprozesse im Wesentlichen in trockene und nasse Oxidationsverfahren eingeteilt werden können. Bei diesen Beschichtungsprozessen wird keine Oxidschicht im eigentlichen Sinne, d.h. als separate Oxidschicht, aufgebracht, da der Sauerstoff direkt mit der Halbleiterschicht reagiert, wodurch ein Teil der Oberfläche der Halbleiterschicht in eine Oxidschicht umgewandelt wird. Der Sauerstoff wird folglich in gewisser Weise in die Halbleiterschicht eingebaut.

Trockene Oxidationsverfahren werden üblicher Weise bei hohen Temperaturen durchgeführt, wobei die jeweiligen Temperaturen vom Material der Halbleiterschicht abhängen. Beispielsweise kann die thermische Oxidation bei Temperaturen von 800 bis 1200°C durchgeführt werden, indem die Halbleiteroberfläche einer Sauerstoff enthaltenden Atmosphäre, wie beispielsweise reinem Sauerstoff oder einem Gemisch aus Sauerstoff und Wasserstoff, ausgesetzt wird.

Ein anderes Verfahren nutzt Wasserdampf als Oxidationsmittel, welches auch als nasse Oxidation bezeichnet wird. Dazu durchströmt ein Trägergas, häufig Sauerstoff oder ein Sauerstoff-Stickstoff-Gemisch, einen sogenannten Bubbler bevor es in Kontakt mit der Halbleiterschicht tritt, wobei die durch das Trägergas transportierten Wassermoleküle anschließend mit der Oberfläche der Halbleiterschicht reagieren. Diese Oxidationsreaktion läuft in der Regel bei Temperaturen zwischen 900°C und 1100°C ab.

Die erzielte Schichtdicke der Oxidschicht ist dabei abhängig von der Temperatur und der Oxidationszeit. Vorzugsweise wird die Schichtdicke der Oxidschicht derart eingestellt, dass sie 10 bis 50%, mehr bevorzugt 15 bis 40%, besonders bevorzugt 20 bis 30% der Dicke der Halbleiterschicht beträgt. Aus Stabilitätsgründen beträgt die Schichtdicke der Oxidschicht jedoch mindestens 50 nm, unabhängig von der Halbleiterschichthöhe.

Erfindungsgemäß können in der Halbleiterschicht Dotierstoffe eingebracht sein, welche die Ausbildung der Oxidschicht unterstützen. Zudem kann vor der Oxidation die Oberfläche der Halbleiterschicht gegebenenfalls gereinigt werden, wobei insbesondere metallische Verunreinigungen reduziert werden sollen. Ein typischer Reinigungsprozess ist die RCA-Reinigung, die Chlorwasserstoff (HCl) zur Bindung von metallischen Verunreinigungen nutzt. Es können jedoch auch andere Reinigungsprozesse unter Verwendung anderer Verbindungen, wie beispielsweise organische Chlorverbindungen, wie z.B. 1,2-Dichlorethen, eingesetzt werden.

Wie vorstehend beschrieben kann die Bereitstellung der Oxidschicht auch durch Aufbringen einer separaten Halbleiter-Oxidschicht erfolgen. Dies ist insbesondere von Vorteil, wenn die gegebene Halbleiterschichthöhe nicht durch die Oxidation beeinträchtigt werden soll. Hierbei kann eine entsprechende Oxidschicht durch im Stand der Technik bekannte Abscheideverfahren aufgebracht werden. Als nichtlimitierende Abscheideverfahren können beispielsweise die TEOS-Abscheidung und die Silanpyrolyse genannt werden.

Falls die Oxidschicht in Form einer separaten Schicht abgeschieden wird beträgt die Schichtdicke der Oxidschicht vorzugsweise circa 10 nm bis circa 1 $\mu$m, mehr bevorzugt von circa 30 nm bis circa 500 nm, und besonders bevorzugt von 50 nm bis 200 nm.

Nachdem die Oxidschicht auf der Halbleiterschicht bereitgestellt wurde, wird erfindungsgemäß mindestens teilweise auf die der Halbleiterschicht gegenüberliegenden Oberfläche der Oxidschicht eine strukturierte Resistschicht aufgebracht, wodurch Bereiche mit der Resistschicht und Bereiche ohne Resistschicht entstehen. Dies erfolgt derart, dass Bereiche mit der Resistschicht einer Rohform des herzustellenden Metall-Halbleiter-Metall Wellenleiters entsprechen.

Gemäß der vorliegenden Erfindung wird unter dem Begriff einer strukturierten Resistschicht auch eine strukturierte Maskenschicht verstanden, welche die darunterliegende Oxidschicht in nachfolgenden Verfahrensschritten, insbesondere in Ätzschritten, schützt. Das Aufbringen der strukturierten Resistschicht kann durch im Stand der Technik bekannte Verfahren erfolgen.

Beispielsweise kann dies im Rahmen eines Lithographieverfahrens erfolgen. Als Resistschicht kann beispielsweise ein Fotolack bzw. Negativlack eingesetzt werden, der beispielsweise im flüssigen Zustand auf die Oberfläche der Oxidschicht aufgeschleudert, aufgesprüht oder aufgestrichen wird. Andererseits kann die Resistschicht auch im festen Zustand auf die Oberfläche der Oxidschicht aufgebracht, insbesondere aufgeklebt, werden.

Im Allgemeinen können hierzu bestrahlungsempfindliche Materialien (Resistmaterial), beispielsweise polymerisierbares Material, in einem unbehandelten, d.h. nicht-polymerisierten Zustand auf der Oberfläche der Oxidschicht bereitgestellt werden, insbesondere zumindest in dem Bereich, in dem auch der herzustellende Metall-Halbleiter-Metall Wellenleiter, ausgebildet wird.

Wie vorstehend beschrieben, können erfindungsgemäß Positivresists als auch Negativresists verwendet werden. Bei einem Positivresist werden die Bereiche, die einer Behandlung, wie z.B. Belichtung, ausgesetzt werden, für eine anschließend verwendete Entwicklungslösung löslich gemacht, wodurch die nicht behandelten Bereiche der strukturierten Resistschicht auf der Oxidschicht entsprechen. Bei einem Negativlack werden dagegen behandelte Stellen für die weiteren Schritte resistent und verbleiben als strukturierte Resistschicht in Form einer schützenden Passivierungsschicht auf der Oberfläche der Oxidschicht.

Die vorstehenden Materialien für die Ausbildung einer Resistschicht sind dem Fachmann hinlänglich bekannt und können in Abhängigkeit von den entsprechenden Materialien der Halbleiter- und Oxidschicht ausgewählt werden. Als nicht einschränkende Beispiele für Fotolacke können Lacke genannte werden, die als lichtempfindliche Komponente Diazoverbindungen, wie z.B. Diazonaphtochinon bzw. Naphtochinondiazid, und entsprechende Harze bzw. Polymere, wie z.B. Polymethylmethacrylat (PMMA), Novolake oder Epoxidharze enthalten.

Im Falle eines Negativresists können beispielsweise langkettige Wasserstoff-Silsesquioxan (HSQ), Calixarene oder Verbindungen mit partiell cyclisiertem Polyisopropen genannt werden. Die Materialien enthalten außerdem einen geeigneten Filmbildner, z.B. Phenolharzverbindungen. Weitere mögliche Zusätze in der Resistschicht sind u.a. Stabilisatoren und/oder Inhibitoren.

Nachdem das Resistmaterial in einem ersten Bestrahlungsschritt behandelt wurde, wird die Resistschicht einem anschließenden Entwicklungsschritt unterzogen, wodurch in Abhängigkeit vom verwendeten Material entweder die behandelten Bereiche oder die unbehandelten Bereiche des Resistmaterials abgetragen werden. Die Entwicklungslösung ist für jeden eingesetzten Resist spezifisch.

Wie vorstehend beschrieben wird mit Hilfe des Lithographieverfahrens eine strukturierte Resistschicht auf der Oxidschicht erzeugt. Vorzugsweise erfolgt die Strukturierung der Resistschicht mittels Elektronen-, Ionenstrahl- oder Laserlithographie. Besonders bevorzugt erfolgt die Strukturierung der Resistschicht mittels Elektronenstrahllithographie. Als nicht limitierende, konkrete Beispiele können Vistec V6 als Elektronenstrahlschreiber sowie, als Beispiel zur Laserlithographie, DWL 2000 System von Heidelberg Instruments genannt werden, welches einen UV Laser verwendet.

Zur Verbesserung der Hafteigenschaften der Resistschicht auf der Oxidschicht kann vor dem Aufbringen der Resistschicht eine zusätzliche Haftvermittlungsschicht, beispielsweise auf Basis von Hexamethyldisilazan (HMDS), auf die Oxidschicht aufgebracht werden (z.B. Ti-prime, MicroChemicals GmbH, D-89077 Ulm).

Nachdem die strukturierte Resistschicht auf der Oxidschicht aufgebracht wurde, wird erfindungsgemäß die Oxid- und Halbleiterschicht in Bereichen ohne Resistschicht entfernt, wobei mindestens zwei Oberflächen der Halbleiterschicht entstehen. Insbesondere werden in diesem Verfahrensschritt mindestens zwei Oberflächen der Halbleiterschicht freigelegt, indem die vorstehend genannten Bereiche der Oxid- und Halbleiterschicht weggeätzt werden. Dies kann beispielsweise in einem Prozessschritt, aber auch in separaten aufeinanderfolgenden Prozessschritten erfolgen.

Beispielsweise können in einem ersten Ätzschritt die Oxidschicht in Bereichen ohne Resistschicht und in einem anschließenden zweiten Ätzschritt die Halbleiterschicht jeweils unter geeigneten Bedingungen entfernt werden. Hierzu eignen sich insbesondere Trockenätzverfahren. Zu diesen Trockenätzverfahren zählen physikalische Trockenätzverfahren, chemische Trockenätzverfahren sowie physikalisch-chemische Trockenätzverfahren.

Bei den physikalischen Trockenätzverfahren erfolgt der Materialabtrag durch Beschuss mit Ionen, Elektronen oder auch Photonen, wobei der Materialabtrag meist im Vakuum erfolgt.

Die chemischen Trockenätzverfahren basieren auf einer chemischen Reaktion eines meist plasmaaktivierten Gases, wobei sich bildende gasförmige Reaktionsprodukte, wie z.B. $SiF_4$, im Allgemeinen über eine Vakuumpumpe abgesaugt werden.

Zu den physikalisch-chemischen Trockenätzverfahren, die auf der Kombination der vorstehend genannten Verfahren beruhen, zählen das reaktive Ionenätzen (engl.: *reactive ion etching,* RIE), das reaktive Ionentiefätzen (engl.: *deep reactive ion etching,* DRIE), das reaktive Ionenstrahlätzen (engl.: *reactive ion beam etching*) und das HDP-Ätzen (von engl.: *high-density plasma etching*).

Vorzugsweise wird im erfindungsgemäßen Verfahren die Oxid- und/oder Halbleiterschicht in Bereichen ohne Resistschicht durch ein physikalisch-chemisches Trockenätzverfahren entfernt, wobei beispielsweise Trifluormethan ($CHF_3$), Schwefelhexafluorid ($SF_6$), Wasserstoffbromid (HBr) und/oder Sauerstoff, als reaktives Gas (Ätzgas) verwendet werden können ohne auf diese beschränkt zu sein. Die Auswahl des Ätzgases erfolgt in Abhängigkeit des zu ätzenden Materials. Im Falle von Silizium, $SiO_2$ oder Siliziumnitrid, beispielsweise, werden vorzugsweise Fluor oder Chlor enthaltende Ätzgase verwendet. Bei organischen Materialien wird beispielsweise Sauerstoff als Ätzgas verwendet. Das Ätzen erfolgt vorzugsweise durch aufgeladene Teilchen (Ionen), die in einem Gasplasma erzeugt wurden.

Insbesondere wird im erfindungsgemäßen Verfahren vorzugsweise RIE-Ätzen verwendet, welches eine isotrope, d.h. richtungsunabhängige, als auch eine anisotrope Ätzung ermöglicht.

Wie vorstehend beschrieben kann der Schritt des Entfernens der Oxid- und Halbleiterschicht in einem einzigen Ätzschritt oder in separaten aufeinanderfolgenden Prozessschritten erfolgen. Gemäß einer bevorzugten Ausführungsform wird zunächst ein anisotropes RIE-Ätzen durchgeführt, wobei die Oxid- und Halbleiterschicht in Bereichen ohne Resistschicht nacheinander entfernt werden, wodurch die mindestens zwei Oberflächen der Halbleiterschicht freigelegt werden. Die freigelegte Struktur entspricht im Wesentlichen der Rohform (Kontur) des herzustellenden Metall-Halbleiter-Metall Kontakts bzw. Wellenleiters. Hierdurch ist es möglich beispielsweise einen rechteckigen oder quadratischen Querschnitt des herzustellenden Metall-Halbleiter-Metall Wellenleiters zu erhalten.

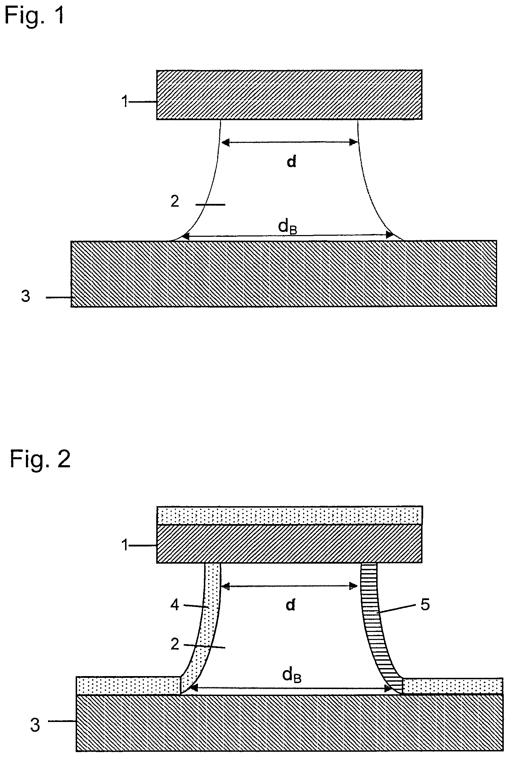

Erfindungsgemäß liegt der Metall-Halbleiter-Metall Wellenleiter insbesondere quasi trapezoid oder rechteckig vor, wobei eine Form, bei der die Halbleiterschicht auf der Substrat zugewandten Seite schmäler ist als auf der Oxidschicht zugewandten Seite bevorzugt ist. Es ist auch möglich, dass der erfindungsgemäße Metall-Halbleiter-Metall Wellenleiter einen trapezartigen Querschnitt mit abgerundeten Flanken (Schenkeln) besitzt. Darüber hinaus kann die Kontur des Metall-Halbleiter-Metall Wellenleiters vorzugsweise derart sein, dass sich im Querschnitt die Halbleiterschicht ausgehend von der Substratseite zur Oxidschicht trapezartig verjüngt, wobei die seitlichen Oberflächen der Halbleiterschicht (die mindestens zwei entstandenen Oberflächen der Halbleiterschicht) beispielsweise in Form einer konkaven Krümmung abgerundet sind. Besonders bevorzugt sind die seitlichen Oberflächen der Halbleiterschicht in Form einer konkaven Krümmung ellipsenförmig ausgebildet, wie dies schematisch in Fig. 1 dargestellt ist.

Diese Formen können beispielsweise dadurch erhalten werden, dass in einem weiteren isotropen Ätzen, insbesondere durch RIE-Ätzen, ein seitliches Unterätzen durchgeführt wird. Vorzugsweise wird dadurch im Querschnitt die Kontur des Metall-Halbleiter-Metall Wellenleiters erzeugt. Hierbei ist es möglich, dass in einem weiteren diesem isotropen Ätzschritt vorgeschalteten Lithographieschritt, insbesondere durch Elektronen- oder Ionenstrahllithographie, entsprechende Bereiche maskiert werden.

Der Metall-Halbleiter-Metall Wellenleiter ist jedoch nicht auf die vorstehenden Formen beschränkt. Entscheidend für die Kontur des Metall-Halbleiter-Metall Wellenleiters ist allein die Unterätzung der Oxidmaske, wodurch ein Kurzschluss verhindert werden kann, und die Dicke der Halbleiterschicht d, die den Wellenleiter definiert. Das Herstellungsziel ist unter anderem eine extrem schmale dielektrische Schicht zwischen zwei unterschiedlichen Metallen. Dafür ist beispielsweise eine unterätzte Maske erforderlich, die fest mit dem zu beschichtenden Substrat verbunden ist. Die Maske dient zur Abschattung bei der gewinkelten Bedampfung. Somit kann ein selektives Aufbringen der Metalle mithilfe einer unterätzten Oxidmaske erfolgen.

Wie vorstehend beschrieben, beträgt die Dicke d der Halbleiterschicht (Bezugszeichen 2 in Fig. 1), welche die nachfolgend beschriebenen Metallschichten trennt, 100 nm oder weniger. Erfindungsgemäß wird als Dicke der Halbleiterschicht die minimale Dicke d betrachtet, welche im Fall einer trapezförmigen Kontur kleiner sein kann als die Dicke $d_B$ der Halbleiterschicht auf der Substratseite. Die Dicke d der Halbleiterschicht kann erfindungsgemäß beliebig klein ausgestaltet sein. Hierin liegt ein erheblicher Vorteil des erfindungsgemäßen Verfahrens, da die Dicke (Querschnittsdicke) des Metall-Halbleiter-Metall Wellenleiters beliebig klein gestaltet werden kann, ohne einen Kurzschluss zu erzeugen.

Vorzugsweise beträgt die Dicke d der Halbleiterschicht 10 nm bis 90 nm, mehr bevorzugt 20 nm bis 80 nm und besonders bevorzugt 30 bis 70 nm.

Erfindungsgemäß weist das herzustellende Bauteil nach dem Schritt des Entfernens der Oxid- und Halbleiterschicht in Bereichen ohne Resistschicht eine Halbleiterschicht mit mindestens zwei (seitlichen) Oberflächen und eine darauf, d.h. auf der der Substratseite gegenüberliegenden Oberfläche, verbliebene Oxidschicht (Bezugszeichen 1 in Fig. 1) mit gewünschter Kontur auf. Gegebenenfalls kann zusätzlich auf der Oxidschicht weiterhin die strukturierte Resistschicht angeordnet sein (in Fig. 1 nicht gezeigt). Üblicher Weise wird die strukturierte Resistschicht jedoch im Rahmen der vorstehend beschriebenen Ätzverfahren entfernt.

Nachdem die Rohform bzw. Kontur des Metall-Halbleiter-Metall Wellenleiters gebildet ist, werden mindestens zwei Schichten aus jeweils unterschiedlichen Metallen durch gewinkelte Bedampfung auf die Oberflächen der Halbleiterschicht unter Bildung des Metall-Halbleiter-Metall Wellenleiters aufgebracht. Erfindungsgemäß werden diese Metallschichten derart aufgebracht, dass die erste Metallschicht nicht in direktem Kontakt mit der zweiten Metallschicht steht, wodurch ein Kurzschluss vermieden werden kann. Die Trennung dieser Metallschichten bzw. die Vermeidung eines Kurzschlusses während des Bedampfungsschritts wird durch die verbliebene Oxidschicht ermöglicht, wie dies schematisch in Fig. 2 dargestellt ist. Demnach wird eine erste Metallschicht (Bezugszeichen 4 in Fig. 2) mindestens auf einer Oberfläche der Halbleiterschicht aufgebracht. Eine von der ersten Metallschicht verschiedene zweite Metallschicht (Bezugszeichen 5 in Fig. 2) wird mindestens auf einer weiteren Oberfläche der Halbleiterschicht aufgebracht.

Vorzugsweise wird die erste Metallschicht (4) mindestens auf einer ersten Oberfläche der Halbleiterschicht und die zweite Metallschicht (5) auf der der ersten Oberfläche gegenüberliegenden Oberfläche der Halbleiterschicht aufgetragen. Wie in Fig. 2 schematisch dargestellt, kann die erste Metallschicht (4) bzw. die zweite Metallschicht (5) zudem auf dem Substrat (Bezugszeichen 3 in Fig. 2) und/oder auf der Oxidschicht, gegebenenfalls auf der vorhandenen Resistschicht, aufgebracht werden.

Das Aufbringen der mindestens zwei Schichten aus jeweils unterschiedlichen Metallen erfolgt erfindungsgemäß durch gewinkelte Bedampfung. Dies erfolgt vorzugsweise in nacheinander folgenden Bedampfungsschritten (Metallisierungsschritten). Die Bedampfungen zur Beschichtung der Halbleiterseitenwände erfolgt unter Winkeln von größer 45° bzw. kleiner -45° zur Oberflächennormalen des Substrats. Weitere, gegebenenfalls gewinkelte, Bedampfungen definieren die von außen kontaktierbaren Elektroden und bewerkstelligen einen elektrischen Kontakt zwischen den auf den Seitenwänden aufgebrachten Materialien und den Kontaktelektroden.

Erfindungsgemäß werden auf den beiden Oberflächen der Halbleiterschicht dadurch unterschiedliche Metallschichten aufgebracht, wobei die jeweiligen Schichtdicken der Metallschichten vorzugsweise im Subnanometerbereich bis hin zum Bereich weniger Nanometer liegen. Bevorzugt betragen die jeweiligen Schichtdicken der Metallschichten 0,1 nm bis 80 nm, mehr bevorzugt 10 nm bis 60 nm, besonders bevorzugt 20 nm bis 50 nm. Zur Bestimmung der Schichtdicken können entsprechende Messgeräte während der Bedampfung, beispielsweise Schwingquarze, eingesetzt werden. Eine weitere Möglichkeit der Schichtdickenbestimmung ist durch das Brechen ("dicen") einer Beispielprobe und das Ausmessen der seitlich angelagerten Metallschichten mittels Rasterelektronenmikroskopie. Die seitlich aufgebrachten Metallschichten können dabei von gleicher oder unterschiedlicher Schichtdicke sein.

Die unterschiedlichen Metallschichten sind nicht besonders beschränkt und können in Abhängigkeit vom gewünschten Einsatzzweck des erfindungsgemäßen Bauteils ausgewählt werden. Hierin liegt ein erheblicher Vorteil des erfindungsgemäßen Verfahrens, da aktive und passive plasmonische Bauteile aus beliebigen aufdampfbaren Materialien hergestellt werden können. So können anstatt von Metallen zunächst nichtlineare elektro-optische Materialien oder Lasermedien aufgebracht werden, die dann durch wie oben beschriebenen Metallisierungsschritte sowohl mit einem äußeres elektrisches Feld als auch einem eingekoppelten Lichtfeld interagieren können. So lassen sich unter anderem elektro-optische Modulatoren bzw. plasmonische Verstärker und Laserquellen realisieren. Die nicht direkt in Kontakt stehenden Elektroden sorgen durch ihre geringe Distanz für ein starkes elektrisches Feld schon bei relativ geringen Spannungen, so dass die Effizienz von Licht-Materie Interaktion, die von der Feldstärke abhängen, gesteigert werden kann.

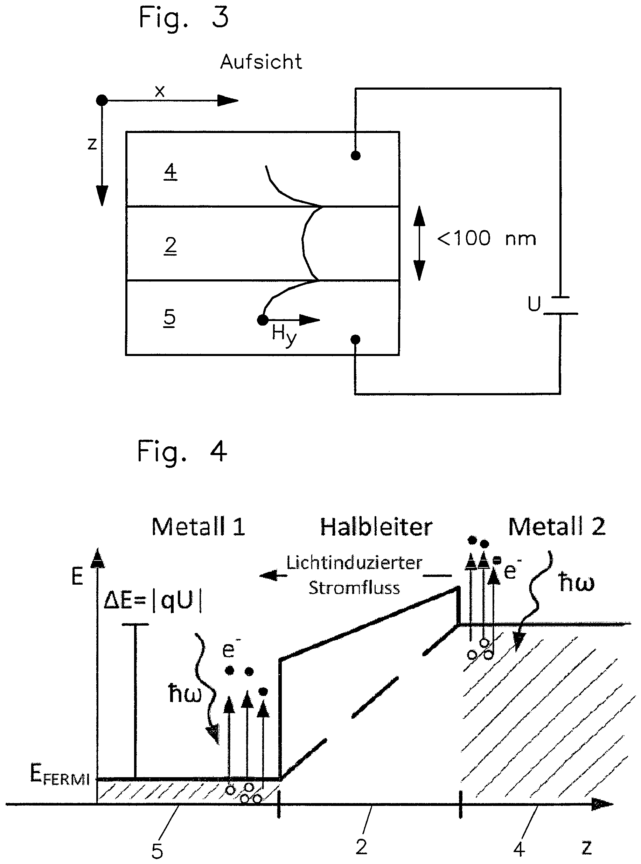

Im Falle der Anwendung des Metall-Halbleiter-Metall Wellenleiters als Photodetektor, ist es aus Gründen der Quanteneffizienz bevorzugt, dass die Metallschichten derart ausgewählt werden, dass elektromagnetische Wellen überwiegend in einer Metallschicht absorbiert werden, wohingegen die zweite Metallschicht insbesondere als Gegenelektrode wirkt, welche die elektromagnetischen Wellen führt. Wie in Fig. 3 schematisch dargestellt, wird im erfindungsgemäßen plasmonischen Bauteil ein Oberflächenplasmon, dargestellt als Amplitudenprofil, im Metall-Halbleiter-Metall Wellenleiter geführt.

Erfindungsgemäß enthalten die zwei Metallschichten jeweils unterschiedliche Metalle, d.h. jede Metallschicht enthält mindestens ein Metall, welches zu mindestens einem Metall der anderen Schicht unterschiedlich ist.

Die erste Metallschicht besteht erfindungsgemäß aus einem Metall, ausgewählt aus der Gruppe, bestehend aus Gold, Silber und Aluminium sowie deren Legierungen. Besonders bevorzugt sind Gold und Silber.

Erfindungsgemäß besteht die zweite Metallschicht aus Titan, Chrom, Zirkonium, Nickel, Palladium, Platin, Zinn, Blei, Bismut und Kupfer sowie deren Legierungen. Als zweite Metallschicht sind besonders bevorzugt Titan, Kupfer und Chrom sowie deren Legierungen.

Aus Gründen der Quanteneffizienz werden die Metallschichten derart ausgewählt, dass das Metall der zweiten, stark absorbierenden Metallschicht eine geringere Potentialbarriere zur Halbleiterschicht aufweist.

In einer besonders bevorzugten Ausführungsform der vorliegenden Erfindung bestehen die erste Metallschicht aus Gold und die zweite Metallschicht aus Titan.

Wie vorstehend beschrieben, kann Licht der Energie $\hbar\omega$, die nicht ausreicht um direkte Band-Band-Übergänge im Halbleiter zu erzeugen, in diesen Wellenleitern in Form eines Oberflächenplasmons geführt werden. Einzelne Elektronen im Metall gehen durch Absorption in einen höheren Energiezustand über (sogenannte "hot electrons"). Damit erhöht sich die Wahrscheinlichkeit, dass diese energiereichen Elektronen die Potentialbarriere zwischen Halbleiter und Metall überwinden, was zu einer lichtinduzierten Ladungstrennung und somit einem messbaren Strom führt.

Eine über dem Übergang angelegte Spannung bewirkt nun abhängig von der Polung entweder eine Unterstützung bzw. ein Entgegenwirken des Stromflusses über dieser Barriere. Ein solcher Übergang zeigt daher das Verhalten eines Photodetektors, da der Stromfluss in eine Richtung unterbunden ist.

Daher betrifft ein weiterer Gegenstand der vorliegenden Erfindung ein Verfahren zur Herstellung eines plasmonischen Photodetektors unter Verwendung des erfindungsgemäßen Verfahrens zur Herstellung des plasmonischen Bauteils, wobei das plasmonische Bauteil an eine anzulegende Spannung gekoppelt wird. In diesem Fall kann das plasmonische Bauteil auch als aktive plasmonische Komponente bezeichnet werden.

Vorzugsweise wird das erfindungsgemäße plasmonische Bauteil direkt an einen photonischen Siliziumwellenleiter angekoppelt.

Das erfindungsgemäße Verfahren kann gegebenenfalls weitere Schritte umfassen. Beispielsweise kann in einem zusätzlichen Schritt das vorstehend beschriebene Substrat vom Metall-Halbleiter-Metall Kontakt abgelöst werden, so dass das plasmonische Bauteil, insbesondere der Wellenleiter, als Freiformstruktur vorliegt. Diese Freiformstruktur kann zum Beispiel als "SNOM" Spitze verwendet werden, die das sogenannte Near-Field eines optischen Bauteils auflösen kann. Hierbei können Lichtaufnahme und Detektion am selben Ort stattfinden.

Darüber hinaus können im erfindungsgemäßen Verfahren weitere Beschichtungen auf den Metall-Halbleiter-Metall Kontakt aufgebracht werden. Dadurch ist es möglich, dass das erfindungsgemäße plasmonische Bauteil als Verstärker, Elektro-Optischer Wandler oder Phasenschieber funktionalisiert wird. Die freiliegenden Seiten der Halbleiterstruktur ermöglichen es prinzipiell, weitere beliebige Materialien aufzubringen, die verdampft werden können, wie beispielsweise Isolatoren oder andere Halbleiter. Auf diesen abgeschiedenen Materialien können wiederum durch gewinkelte Bedampfungen Metalle abgeschieden werden, die so einen elektrisch kontaktierbaren plasmonischen Wellenleiter bilden.

Aus der Schichtabfolge Metall(1)-Oxid-Halbleiter-Metall(2) kann zum Beispiel ein Absorptionsmodulator entstehen: Anlegen einer negativen Spannung an Metall(2) bewirkt eine Erhöhung der Ladungsträgerdichte (Elektronen) im Halbleiter. Diese freien Ladungsträger erhöhen die Absorption des Oberflächenplasmons (freecarrier absorption), das im plasmonischen Wellenleiter geführt wird. Durch Modulation der angelegten Spannung kann dementsprechend die Intensität des austretenden Lichts moduliert werden.

Zudem können gegebenenfalls Schutzschichten abgeschieden werden, wodurch das plasmonische Bauteil insbesondere vor nachträglichen unerwünschten mechanischen und/oder chemischen Einflüssen geschützt wird.

Durch das erfindungsgemäße Verfahren wird ein plasmonisches Bauteil mit einem Metall-Halbleiter-Metall Kontakt bzw. Metall-Halbleiter-Metall Wellenleiter erhalten, bei welchem eine erste Metallschicht von einer von der ersten Metallschicht verschiedenen zweiten Metallschicht durch eine Halbleiterschicht mit einer Dicke von weniger als 100 nm getrennt ist, wobei die erste Metallschicht nicht in direktem Kontakt mit der zweiten Metallschicht steht.

Erfindungsgemäß weist das plasmonische Bauteil vorzugsweise ferner eine Oxidschicht auf, welche die erste Metallschicht von der zweiten Metallschicht trennt. Dadurch kann ein möglicher Kurzschluss zwischen den Metallschichten bzw. den Elektroden vermieden werden. Wie vorstehend beschrieben, weist der Metall-Halbleiter-Metall Wellenleiter des erfindungsgemäßen plasmonischen Bauteils vorzugsweise einen trapezartigen Querschnitt mit beispielsweise abgerundeten Flanken (Schenkeln) auf.

In einer weiteren Ausführungsform kann das plasmonische Bauteil ferner ein Substrat umfassen, auf welchem der Metall-Halbleiter-Metall Kontakt angeordnet ist. Erfindungsgemäß ist die Kontur des Metall-Halbleiter-Metall Kontakts, insbesondere des Wellenleiters, vorzugsweise derart, dass sich im Querschnitt der Metall-Halbleiter-Metall Kontakt ausgehend von der Substratseite zur Oxidschicht trapezartig verjüngt, wobei die seitlichen Metallschichten vorzugsweise in Form einer konkaven Krümmung abgerundet sind. Besonders bevorzugt sind die seitlichen Oberflächen der Metallschichten in Form einer konkaven Krümmung ellipsenförmig ausgebildet, wie dies schematisch in Fig. 2 dargestellt ist.

Es ist jedoch nicht zwingend erforderlich, dass der Metall-Halbleiter-Metall Kontakt auf einem Substrat angeordnet ist. Wie vorstehend beschrieben kann das erfindungsgemäße plasmonische Bauteil, insbesondere der Wellenleiter, als Freiformstruktur, d.h. freistehend, vorliegen.

Die Dicke (Gesamtdicke) des Metall-Halbleiter-Metall Kontakts bzw. des Wellenleiters ist nicht besonders beschränkt. In Abhängigkeit von den jeweiligen Schichtdicken der Metallschichten kann die Gesamtdicke 200 nm oder weniger, mehr bevorzugt 160 nm oder weniger, besonders bevorzugt 120 nm oder weniger betragen. Als (Gesamt-)Dicke des Metall-Halbleiter-Metall Kontakts bzw. des Wellenleiters wird in analoger Weise zur vorstehend beschriebenen Dicke d der Halbleiterschicht, die minimale Dicke des Metall-Halbleiter-Metall Kontakts betrachtet.

Die Höhe des Metall-Halbleiter-Metall Kontakts bzw. des Wellenleiters ist nicht besonders beschränkt. Da jedoch der Dunkelstrom mit der Fläche des Kontakts steigt, sollte diese möglichst klein sein. Beispielsweise kann die Höhe des Metall-Halbleiter-Metall Kontakts bzw. des Wellenleiters circa 50 nm bis 1 $\mu$m, vorzugsweise circa 100 bis 500 nm, besonders bevorzugt circa 200 bis 340 nm betragen.

Die Länge des Metall-Halbleiter-Metall Kontakts bzw. des Wellenleiters, d.h. die Ausdehnung in X-Richtung, wie in Fig. 3 gezeigt, beträgt vorzugsweise 100 $\mu$m oder weniger, mehr bevorzugt 50 $\mu$m oder weniger, besonders bevorzugt 20 $\mu$m oder weniger. Gemäß einer besonders bevorzugten Ausführungsform beträgt die Länge des Metall-Halbleiter-Metall Kontakts bzw. des Wellenleiters 10 $\mu$m oder weniger. In allen Ausführungsformen beträgt die minimale Länge vorzugsweise 0,5 $\mu$m.

Wie vorstehend beschrieben, eignet sich das erfindungsgemäße plasmonische Bauteil auf Grundlage der internen Photoemission insbesondere zur Photodetektion.

Ein weiterer Gegenstand der vorliegenden Erfindung betrifft daher einen plasmonischen Photodetektor, umfassend ein plasmonisches Bauteil mit einem Metall-Halbleiter-Metall Kontakt, bei welchem eine erste Elektrode in Form einer ersten Metallschicht von einer zweiten Elektrode in Form einer von der ersten Metallschicht verschiedenen Metallschicht durch eine Halbleiterschicht mit einer Dicke von weniger als 100 nm getrennt ist, wobei die erste Metallschicht nicht in direktem Kontakt mit der zweiten Metallschicht steht. Diese Metallschichten werden zur Photodetektion und gleichzeitig als Elektroden zum Anschluss an einen externen Stromkreis verwendet.

Wie vorstehend beschrieben, ist es bevorzugt, dass die Metallschichten derart ausgewählt werden, dass elektromagnetische Wellen überwiegend in einer Metallschicht absorbiert werden, die die photoaktive Elektrode darstellt, wohingegen die zweite Metallschicht vorzugsweise die Gegenelektrode darstellt.

Vorzugsweise ist im erfindungsgemäßen plasmonischen Photodetektor das plasmonische Bauteil direkt an einen photonischen Siliziumwellenleiter angekoppelt. Der Umstand, dass im photonischen Wellenleiter geführtes Licht im plasmonischen Wellenleiter auf wenige zehn Nanometer fokussiert werden kann, führt zu hohen Quanteneffizienzen, großen Bandbreiten und kurzen Gerätelängen im Bereich weniger Mikrometer.

Der erfindungsgemäße plasmonische Photodetektor ermöglicht die Detektion elektromagnetischer Wellen im sichtbaren Bereich (Wellenlängen im Bereich von 380 nm bis 780 nm) als auch infraroten Bereich (Wellenlängen zwischen 780 nm und 1 mm) des Spektrums. Daher kann der erfindungsgemäße plasmonische Photodetektor sowohl in der hochintegrierten optischen Kommunikationstechnik im Infrarotbereich (IR-Bereich) als auch in der Photodetektion im sichtbaren Bereich eingesetzt werden. Vorzugsweise wird der erfindungsgemäße plasmonische Photodetektor in der Photovoltaik verwendet.

Der erfindungsgemäße plasmonische Photodetektor zeichnet sich durch hohe Quanteneffizienzen aus, die im Vergleich zu im Stand der Technik bekannten Systemen zur Lichtdetektion auf Grundlage der internen Photoemission deutlich erhöht sind. Insbesondere weist der erfindungsgemäße plasmonische Photodetektor eine Quanteneffizienz von mindestens 2% auf. Vorzugsweise liegt die Quanteneffizienz des plasmonischen Photodetektors im Bereich von 5 bis 50%, besonders bevorzugt von 10 bis 30%. In diesem Zusammenhang soll darauf hingewiesen werden, dass die Quanteneffizienz von der Wellenlänge abhängt, wobei sich für kleinere Wellenlängen höhere Effizienzen ergeben. Die Quanteneffizienz kann zum Beispiel durch Vergleich mit einer Referenzdiode erhalten werden, für die die Responsivität bekannt ist.

Zudem zeichnet sich der erfindungsgemäße plasmonische Photodetektor durch eine verbesserte elektrische Bandbreite aus. Insbesondere weist der erfindungsgemäße plasmonische Photodetektor vorzugsweise eine elektrische Bandbreite von mehr als 100 GHz auf.

Wie vorstehend beschrieben, weisen im Stand der Technik bekannte Methoden zur Herstellung plasmonischer Bauteile unterschiedliche Nachteile auf. Bedingt durch technologische Beschränkungen ist es vor Allem schwierig mehrschichtige, aus verschiedenen Materialien (Metallen und Isolatoren/Halbleiter) bestehende plasmonische Strukturen ohne Kurzschluss der Elektroden, die nur 100 nm voneinander entfernt sind, kontrolliert aufzubauen.

Durch die vorliegende Erfindung ist es möglich, ultrakompakte plasmonische Bauteile, insbesondere in Form von Wellenleitern, sowie plasmonische Photodetektoren hoher Qualität mit einer erhöhten Quanteneffizienz und einer verbesserten elektrischen Bandbreite bereitzustellen, die eine im Vergleich zu konventionellen Photodioden höhere Integrationsdichte erlauben. Darüber hinaus zeichnet sich die vorliegende Erfindung dadurch aus, dass trotz der kompakten Ausmaße des plasmonischen Bauteils ein Kurzschluss zwischen den Metallschichten, die auch als Elektroden verwendet werden können, vermieden wird.

Wie vorstehend beschrieben, wird eine Erhöhung der Quanteneffizienz der internen Photoemission (Überwindung einer Potentialbarriere mit Elektronen entweder ballistisch oder durch den Tunneleffekt) dadurch erreicht, dass die sich unterscheidenden Metalle der Metallschichten vorzugsweise derart ausgewählt werden, dass die Potentialbarrieren und die Absorption am Ort der Photoemission optimiert sind.

Aus dem Stand der Technik sind Plasmonische Bauteile bekannt, wobei die Elektroden jedoch alle aus demselben Metall hergestellt wurden. Für die erfindungsgemäßen Bauteile sind jedoch zwei unterschiedliche Metalle für die Elektroden erforderlich, um die Aufgabe auf der Basis der beschriebenen Effekte, insbesondere einer Tunnelung, umfassend zu lösen. Vorzugsweise ist die Wahl der Metalle derart, dass die tunnelfähigen Ladungsträger in nur einem Metall erzeugt werden und dieses Metall gleichzeitig die geringere Austrittsarbeit zum Halbleiter aufweist, für die effiziente Ausnutzung des Tunneleffekts und damit für die Funktion des erfindungsgemäßen Bauteils ausschlaggebend.

Im Stand der Technik wird der Tunneleffekt zwar auch genannt, aber allgemein und ohne einen konkreten Bezug zu den vorgenannten unterschiedlichen Metallen und deren optischen wie elektronischen Eigenschaften. Im Stand der Technik sind nur Bauteile offenbart, die einen Potentialgradienten nutzen, wobei im Rahmen der Anmeldung die Nutzung des Tunneleffekts bei getrennten Ladungsträger genutzt wird. Im Stand der Technik wird zudem eine Lösung zur Erzielung der Potentialdifferenzen beschrieben, die erfindungsgemäß eben durch unterschiedliche Metalle für benachbarte Elektroden gelöst wird.

Ferner sind als Herstellungsverfahren aus dem Stand der Technik Gravierverfahren bekannt, welche sich grundsätzlich von dem erfindungsgemäßen Verfahren unterscheiden. Auch wenn im Stand der Technik ein Wirkspalt auch von unter 50nm beschrieben wird, wäre dieser mit einem Gravieren grundsätzlich nicht herstellbar.

Die vorliegende Erfindung wird nachfolgend anhand von nicht einschränkenden Beispielen mit Bezug auf die beiliegenden Figuren näher erläutert. Dabei zeigen:

Fig. 1:     eine schematische Darstellung einer beispielhaften Kontur des herzustellenden Metall-Halbleiter-Metall Kontakts mit einem Substrat, einer Halbleiterschicht und einer Oxidschicht;

Fig. 2:     eine schematische Darstellung im Querschnitt eines Metall-Halbleiter- Metall Kontakts gemäß einer bevorzugten Ausführungsform der vorliegenden Erfindung;

Fig. 3:     eine vereinfachte schematische Darstellung (Ansicht von oben) eines erfindungsgemäßen Metall-Halbleiter-Metall Kontakts, wobei das Amplitudenprofil den Verlauf des magnetischen Feldes der geführten Mode zeigt;

Fig. 4:     eine vereinfachte schematische Querschnittsdarstellung eines asymmetrischen Metall-Halbleiter-Metall Kontakts mit lichtinduzierter Ladungstrennung zur Veranschaulichung der internen Photoemission, was bei angelegter Spannung zu einem messbaren Strom führt;

Fig. 5:     eine schematische Darstellung im Querschnitt eines Metall-Halbleiter- Metall Kontakts gemäß einer besonders bevorzugten Ausführungsform der vorliegenden Erfindung;

Fig. 6:     simulierte Normen des elektrischen Feldes in Abhängigkeit von der Dicke d;

Fig.        7A:das Verhältnis der Verlustleistungen in Titan- und Goldelektroden;

Fig. 7B:die  Eindringtiefe, i.e. die Absorptionslänge, d.h. die Länge nach der die Intensität des optischen Signals aufgrund Absorption auf 1/e abgefallen ist;

Fig. 8:     schematische Verfahrensschritte des erfindungsgemäßen Verfahrens;

Fig. 9:     Rasterelektronenmikroskop-Aufnahmen einer Wellenleiterstruktur gemäß einer besonders bevorzugten Ausführungsform der vorliegenden Erfindung;

Fig. 10:    ein optisches Setup für die Messung von photoinduzierten Strömen;

Fig. 11:    die Abhängigkeit des Photostroms ohne angelegter Spannung;

Fig. 12:    gemessene Photoströme in Abhängigkeit von der einfallenden Lichtenergie, wobei jede Linie einer unterschiedlichen angelegten Spannung entspricht;

Fig. 13:    die Abhängigkeit der Photoströme von der angelegten Spannung mit subtrahierten Dunkelströmen;

Fig. 14:    einen optischen Micrographen eines PMMA Resists, der Elektroden eines plasmonischen Wellenleitersdefiniert;

Fig. 15:    eine Rasterelektronenmikroskop-Aufnahme eines metallisierten Photodetektors gemäß einer bevorzugten Ausführungsform der vorliegenden Erfindung; und

Fig. 16:    Dunkelströme von 10 $\mu$m und 20 $\mu$m langen plasmonischen Photodetektoren, wobei der Dunkelstrom nahe an der maximalen Auflösung des verwendeten Instruments ist.

Simulierung optischer Eigenschaften von Metall-Halbleiter-Metall Kontakten

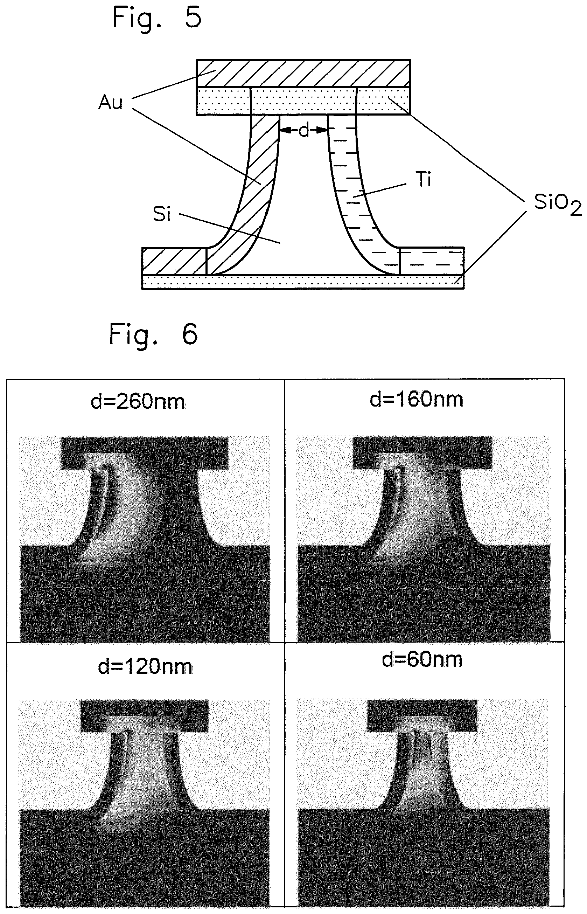

Im Folgenden wird auf den in Fig. 5 dargestellten Metall-Halbleiter-Metall Kontakt in Form eines Wellenleiters Bezug genommen. Dieser besteht aus einem Silizium-Nanodraht mit elliptischen Seitenwänden, wobei dessen Basisfläche im Querschnitt breiter ist als am oberen Ende. Eine Goldschicht ist auf der linken Oberfläche des Wellenleiters und eine Titanschicht auf der rechten Oberfläche des Wellenleiters abgeschieden. Die Wellenleitergeometrie entspricht tatsächlich hergestellten Wellenleitern, wie nachfolgend beschrieben wird.

Die optischen Eigenschaften des Wellenleiters wurden mit Hilfe von COMSOL (Comsol 4.3a Simulationsmodul: Electro-magnetic waves, frequency domain) simuliert, wobei die elektrische Feldverteilung (fundamental guided mode) und die Absorptionscharakteristika jeweils in Abhängigkeit von der Dicke d des Wellenleiters untersucht wurden. Diese Simulierungen wurden bei einer optischen Wellenlänge von 1270 nm durchgeführt.

Anhand Fig. 6 ist zu erkennen, dass je schmäler der Wellenleiter ist, umso eingeengter das elektrische Feld des jeweiligen Wellenleiters ist. Darüber hinaus zeigt sich, dass sich die Eindringtiefe des Feldes hin zur rechten Seite mit der Titanschicht mit abnehmender Dicke d erhöht. Da Titan bei der gewählten Wellenlänge im Vergleich zu Gold viel stärker absorbiert, erhöht sich auch der im Titan absorbierte Lichtanteil mit abnehmender Dicke d.

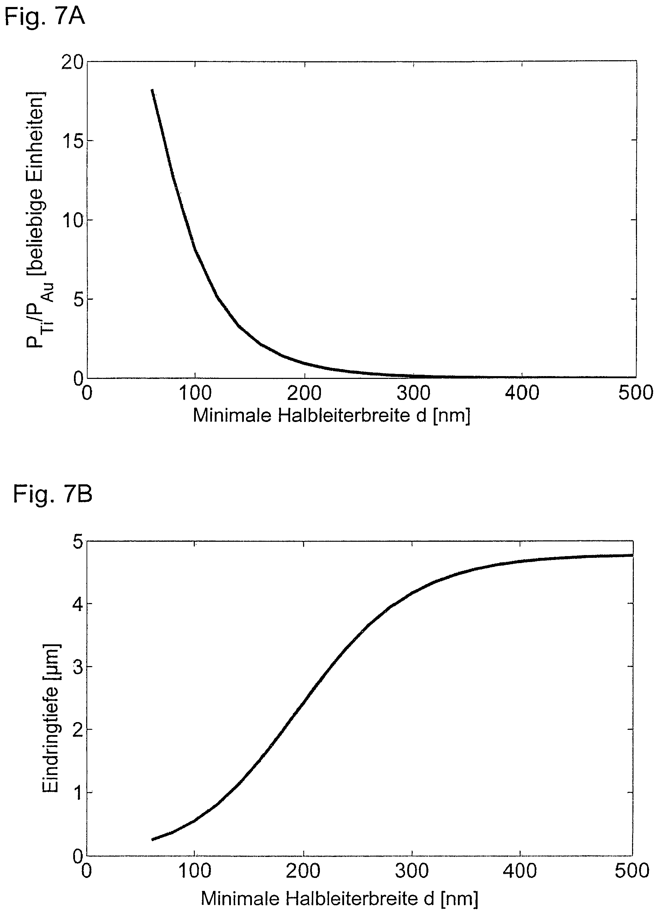

Um die Dichte der Leistungsverluste in den Elektroden zu bestimmen, welche die photoinduzierten Ladungsträger erzeugen, wurden die Verlustleistungen in jeder Elektrode numerisch integriert. Fig. 7(A) zeigt das Verhältnis der Verlustleistungen in Titan und Gold. Mit kleiner werdenden d erhöht sich der Anteil der Verlustleistung in Titan in nichtlinearer Weise. Für einen Wellenleiter mit einer Breite von 100 nm, übertrifft die Photoerzeugung in Titan die in Gold um einen Faktor von 10. Der erhöhte Verlust in der Titanelektrode ist von einer verminderten Eindringtiefe in den Wellenleiter begleitet, wie in Fig. 7(B) zu sehen ist.

Für Wellenleiter mit einer Breite von weniger als 100 nm tritt ein Großteil des Leistungsverlusts einzig an der Titanelektrode auf, während eine kurze Eindringtiefe kleine Bauteillängen von weniger als 5 $\mu$m ermöglichen.

### Herstellung photoaktiver plasmonischer Wellenleiter

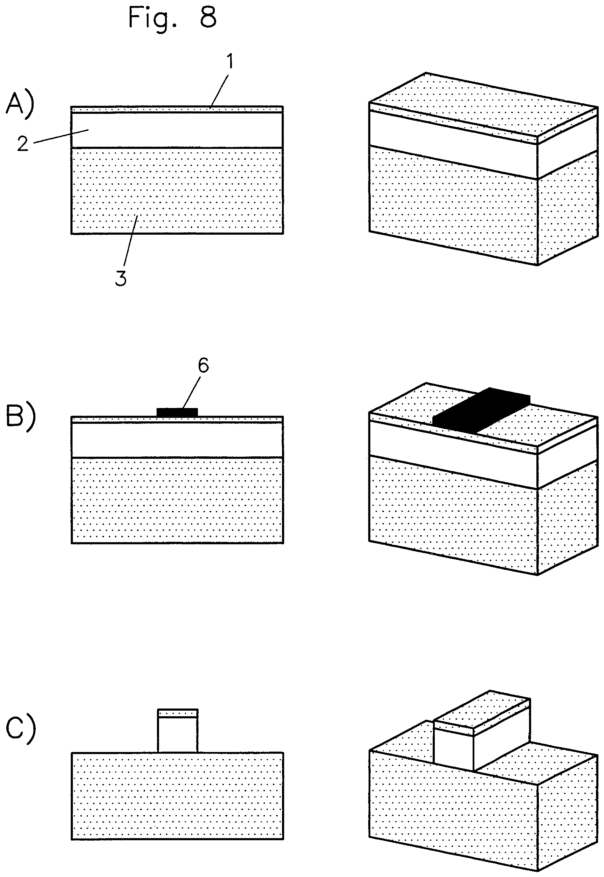

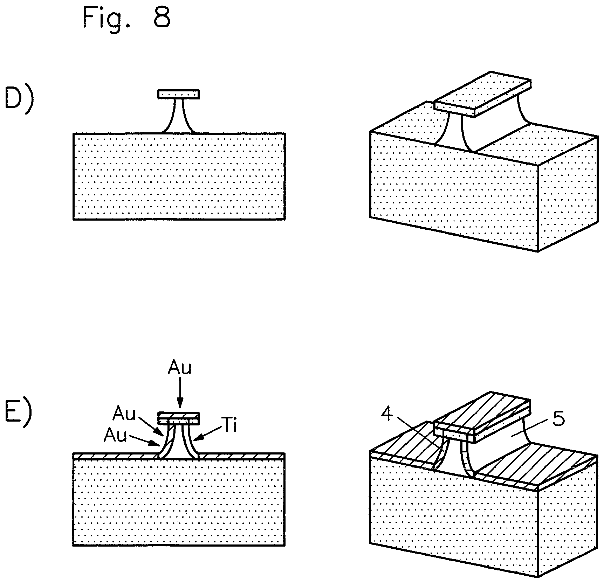

Photoaktive plasmonische Wellenleiter auf SOI-Wafer (engl.: *silicon on insulator*) mit Gold und Titan als Elektrodenmaterialien und einem Elektrodenabstand von weniger als 100 nm wurden wie folgt hergestellt (vgl. auch Fig. 8).

SOI-Wafer mit Bauteildicken von 340 nm wurden thermisch oxidiert bis sich eine 80 nm dicke Oxidschicht auf der Oberfläche des Siliziums ausgebildet hat. Dies erfolgte bei einer Temperatur von 1040°C in einer trockenen Sauerstoffatmosphäre (> 99%) bei 1 bar. Während dieses Prozesses wurde Silizium verbraucht, wobei eine circa 300 nm dicke Siliziumschicht zurückblieb (vgl. Fig. 8A).

Negativresist maN-2401 (von Micro Resist Technology GmbH, Berlin) wurde auf die Oberfläche des oxidierten Wafers schleuderbeschichtet. Unter Verwendung von Elektronenstrahllithographie wurde die Kontur der Wellenleiter, von Markern und Kopplungsbereichen in den Resist geschrieben, wobei der Resist die Oxidschicht in den nachfolgenden Ätzschritten schützt (vgl. Fig. 8B).

CHF$_3$ wurde verwendet, um die ungeschützten Bereiche der Oxidschicht zu entfernen. Mit dem SF$_6$ verwendenden Cryo-Prozess (Temperatur: -115°C, Druck: 5 mTorr, Gasflüsse: 36 sccm SF$_6$, 18 sccm O$_2$, 10 sccm Ar, RF-Leistung: 20 W, ICP-Leistung: 700 W) wurden die Wellenleiter anisotrop in das Silizium eingeätzt. Hierbei fungiert die Oxidschicht auf der Oberfläche als Maske während des Ätzens mit SF$_6$ (vgl. Fig. 8C).

Ein zweites Elektronenstrahllithographieverfahren wurde durchgeführt, um die photonischen Teile im nächsten Ätzschritt zu schützen und um die Elektrodenform festzulegen. Anschließend wurde in einem weiteren isotropen Ätzschritt unter Verwendung von SF$_6$ bei Raumtemperatur der Siliziumwellenleiter seitlich unterätzt (vgl. Fig. 8D).

Hier ist es wichtig, dass in der Prozessierung auch zunächst die unterätzten Bereiche sowie die Elektroden hergestellt werden können und im Anschluss daran die zuführenden Siliziumwellenleiter mit SF$_6$ oder HBr anisotrop hergestellt werden können. Die Reihenfolge der Strukturierung der plasmonischen und rein photonischen Komponenten kann also ausgetauscht werden.

In einer Gesamtzahl von fünf Metallisierungsschritten in fünf Winkeln wurde ein asymmetrischer plasmonischer Wellenleiter hergestellt, der unterschiedliche Metallschichten, einschließlich Goldelektroden, auf jeder Seite aufweist. Die Oxidmaske (Oxidschicht) verhindert dabei, dass sich die beiden Seiten während der Abscheidung kurzschließen. In den ersten beiden Bedampfungen (Metallisierungsschritten) wurden unter einem Winkel von 70° bis 85° zur Oberflächennormalen jeweils Titan bzw. Gold auf den Seitenwänden des unterätzten Siliziums aufgetragen. Damit ist der mit Licht interagierende Teil des Detektors definiert (vgl. Fig. 8E).

Die letzte Bedampfung mit 0° definiert die Elektroden, an denen die externe Elektronik den Photostrom abgreift. Diese Elektroden sind üblicherweise aus Gold oder Aluminium oder einer Legierung aus Titan und Aluminium, um einen möglichst guten elektrischen Kontakt zwischen den Leitern auf dem Chip und der Elektronik zu gewährleisten, wobei die abgeschiedene Metallschicht beispielsweise 100 nm betragen kann.

Die Bedampfungsschritte dazwischen unter einem Winkel von ca. 45° sorgen für einen guten elektrischen Kontakt des plasmonischen Bereichs am Wellenleiter und den Elektroden. Für diese Schritte kann das gleiche Material verwendet werden, wie auch zur Abscheidung der Elektroden verwendet wurde. Zur Photodetektion sind also die ersten beiden Schritte mit unterschiedlichen Metallen ausschlaggebend. Alle weiteren Schritte sorgen für einen guten elektrischen Kontakt nach außen und können mit beliebigen leitfähigen Materialien bewerkstelligt werden.

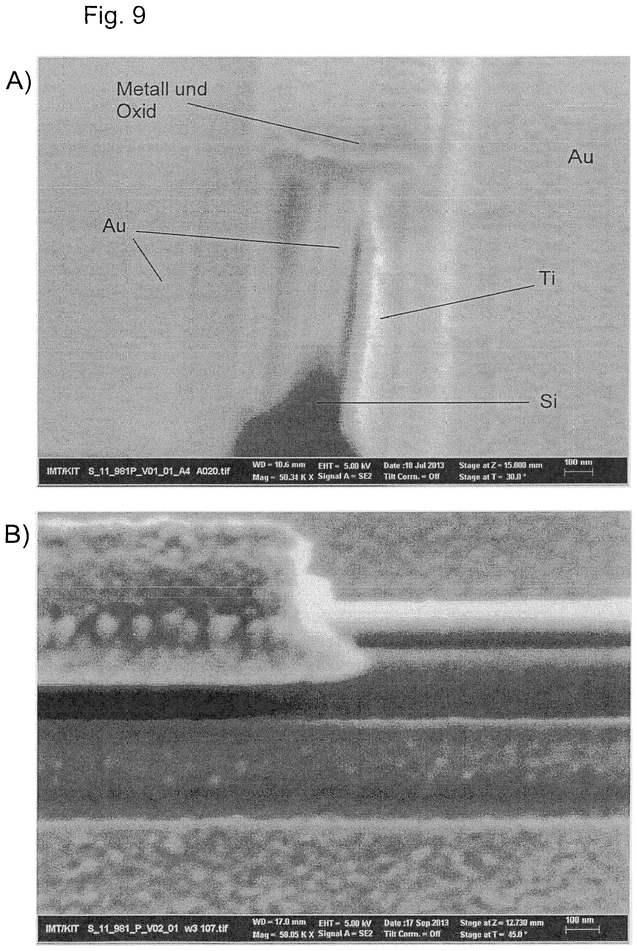

Es wurden plasmonische Wellenleiter mit Längen von mehr als 10 mm auf dem Substrat hergestellt. Das Substrat wurde dann mit einem Diamantschneider angeritzt und gebrochen, sodass eine Bruchkante senkrecht zur Längsrichtung der Wellenleiter entsteht. Diese Bruchkante legt die Facette und damit den Querschnitt des Wellenleiters frei. In Fig. 9 sind Rasterelektronenmikroskop-Aufnahmen des so hergestellten Wellenleiters gezeigt. Das vordere Teil der Oxidschicht wurde durch das Anritzen entfernt, wodurch der darunterliegende Metall-Halbleiter-Metall Kontakt zum Vorschein trat. Die Aufnahmen wurden bei einem Winkel von 45° aufgenommen. Die in Fig. 9(B) dargestellte Aufnahme zeigt die Seitenansicht des Detektors ebenfalls bei einem Winkel von 45°. Der geringste Abstand zwischen den beiden Metallelektroden beträgt weniger als 100 nm.

### Charakterisierung plasmonischer Photodetektoren

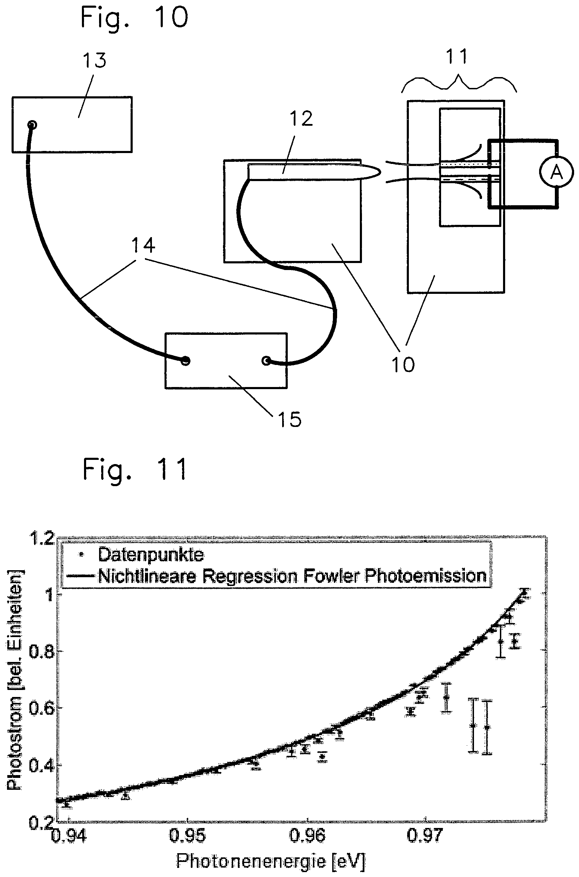

Die freigelegte Facette des plasmonischen Wellenleiters wurde mit einer sich verjüngenden Faser mit einem Brennfleck im Fokus von 5 $\mu$m beleuchtet. Das optische Setup ist in Fig. 10 dargestellt. Es wurde eine einstellbare Laserquelle verwendet, die von 1270 nm bis 1350 nm reicht. Nach sorgfältiger Ausrichtung der Polarisation und der Faserposition wurde der Photostrom in Abhängigkeit von der verwendeten Photonenenergie, von der eintreffenden Laserenergie und von der extern an die Photodiode angelegten Spannung gemessen.

Es wird angenommen, dass der Photostrom eine Potenzgesetz-Abhängigkeit in Bezug auf die Photonenenergie gemäß der von Fowler 1931 vorgestellten Formel für den Photoelektrischen Effekt aufweist. Diese Formel wurde an den Fall interner Photoemission (IPE) angepasst, indem die Höhe der Potentialstufe, gesehen von einem Elektron auf dem Fermi-Niveau (Potential des Fermi-Niveaus subtrahiert vom Potential der Barriere) zwischen Gold und Silizium $\phi_{Au-Si}$ verwendet wurde. Diese Formel trifft für die vorliegende Struktur zu, wenn keine externe Spannung angelegt ist und lautet wie folgt:

$$I_{photo} \propto \frac{(\hbar\omega - \phi_{Au-Si})^2}{(\chi_0 - \hbar\omega)},$$

wobei $\hbar\omega$ die Photonenenergie ist und $\chi_0$ die Gesamthöhe der durch die Grenzfläche gegebenen Potentialstufe ist.

Fig. 11 zeigt die gemessenen Ströme gegenüber der Photonenenergie. Durch Anpassung der Formel an diese Daten unter Verwendung der Methode der gewichteten kleinsten Quadrate, konnte die Barrierehöhe zwischen Gold und Silizium als Parameter erhalten werden. Die erhaltene Barrierehöhe beträgt $\phi_{Au-Si}$ = 0,82 eV, was in guter Übereinstimmung mit Literaturangaben für diese Barrierehöhe ist (vgl. Chen et. al., "Current Transport and its Effect on the Schottky-Barrier Height in a typical System: Gold on Silicon", Solid-State Electronics, Vol. 36, No. 7, S. 949-954, 1993). Diese Übereinstimmung stellt einen ersten Beleg für interne Photoemission (IPE) dar.

Unter Verwendung des Mode-Overlap-Integrals konnte die minimale interne Quanteneffizienz in dieser Struktur abgeschätzt werden, welche für eine optische Wellenlänge von 1270 nm zwischen 5 und 10% beträgt und sich exponentiell für kleinere Wellenlängen erhöht. In dieser Struktur ist die Anwesenheit von IPE nicht auf Photonen unterhalb der Bandlückenenergie des Siliziums beschränkt. Für Photonen höherer Energie, d.h. im sichtbaren Bereich, ist die Absorption im Silizium im Vergleich zu den Metallen um Größenordnungen kleiner.

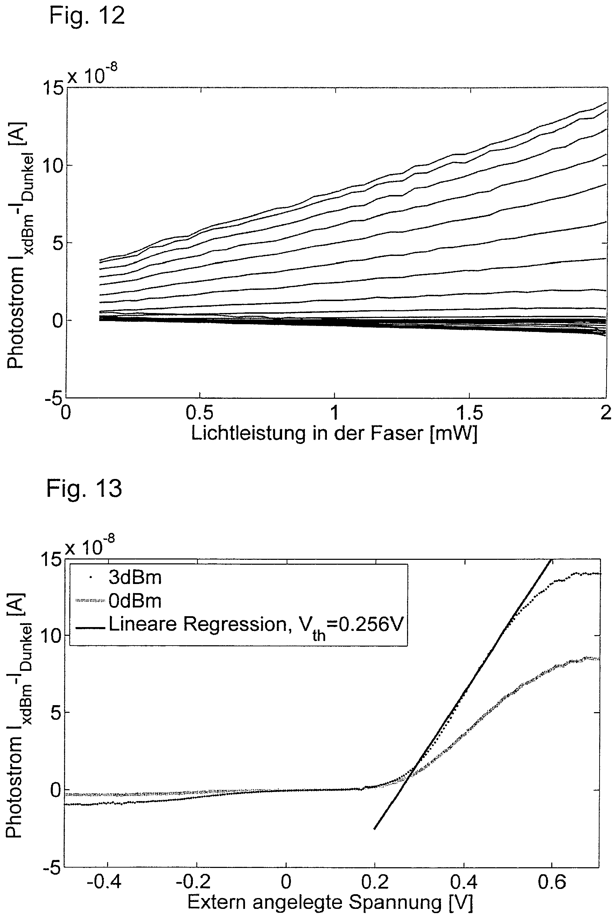

Weitere Messreihen wurden durchgeführt, um die Abhängigkeit des Photostroms von der eintreffenden Laserenergie zu ermitteln. Gemäß der Fowler-Theorie wurde selbst wenn eine externe Spannung angelegt ist ein linearer Anstieg des Photostroms mit der Energie erwartet. Die erhaltenen Ergebnisse sind in Fig. 12 aufgetragen. Jede Linie des Graphen entspricht einer unterschiedlichen angelegten Spannung, wobei die Dunkelströme der Diode subtrahiert wurden. Die niedrigste Kurve wurde bei -0,5 V und die höchste Kurve bei 0,7 V gemessen. Der Unterschied zwischen jeder Kurve beträgt 50 mV.

Wie in Fig. 12 gezeigt erhöht sich der Photostrom mit höheren Spannungen. Positive Ströme entsprechen der Trägerinjekton von Titan, negative Ströme werden vom Gold aus übertragen. Jede gemessene Kurve zeigt eine lineare Abhängigkeit von der Energie. Wie auch in der vorstehenden Simulation diskutiert wurde, zeigt sich dass die Titanelektrode einen größeren Beitrag leistet.

Fig. 13 zeigt die gemessene Photostromabhängigkeit von der angelegten Spannung. Es zeigt sich, dass eine Grenzspannung existiert, die die Ladungsträgerinjektion von Titan von derjenigen des Goldes trennt. Für Spannungen, die größer sind als die Grenzspannung, werden dir Ladungsträger von Titan, für kleinere Spannungen von Gold übertragen. Diese Spannung entspricht dem Diffusionspotential der Diode, das mit $V_{th}$ = 0,256 V berechnet werden kann. Folglich sollte der Unterschied aus der gemessenen Barrierehöhe bei der Gold-Silizium-Grenzfläche und dem Diffusionspotential in der Barrierehöhe bei der Titan-Silizium-Grenzfläche resultieren, d.h. $\phi_{Ti-Si} = \phi_{Au-Si} - qV_{th}$ = 0,564 eV. Dieser Wert liegt im Bereich vorheriger Literaturwerte ($\phi_{Ti-Si}$ = 0,5 eV bis 0,6 eV) (vgl. A.M. Cowley, "Titanium-Silicon Schottky Barrier Diodes", Solid-State Electronics, Pergamon Press 1970, Vol. 12, S. 403-414).

Herstellung ultrakompakter plasmonischer Photowellenleiter

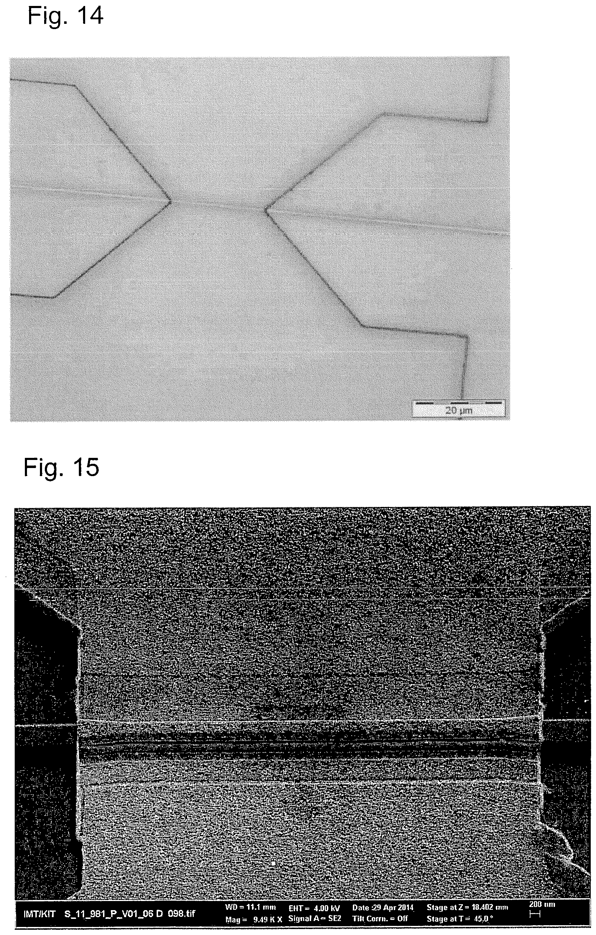

Die Integration aktiver plasmonischer Wellenleiter in eine photonische Siliziumplattform erfordert die Kopplung photonischer und plasmonischer Bereiche. Dies gelang indem zunächst ein photonischer Silizium-Wellenleiter auf einem SOI-Substrat hergestellt wurde. Anschließend wurden die Längen des plasmonischen Bereichs und der der angeschlossenen Elektroden mittels Elektronenstrahllithographie definiert (vgl. Fig. 14), wobei der Siliziumwellenleiter und das Oxidsubstrat für das Ätzen und die Metallabscheidung zugänglich waren. Das vorstehend beschriebene Herstellungsverfahren wurde anschließend an den zugänglichen Teilen des Wellenleiters durchgeführt, wodurch ein Bauteil, wie in Fig. 15 dargestellt, erhalten wurde.

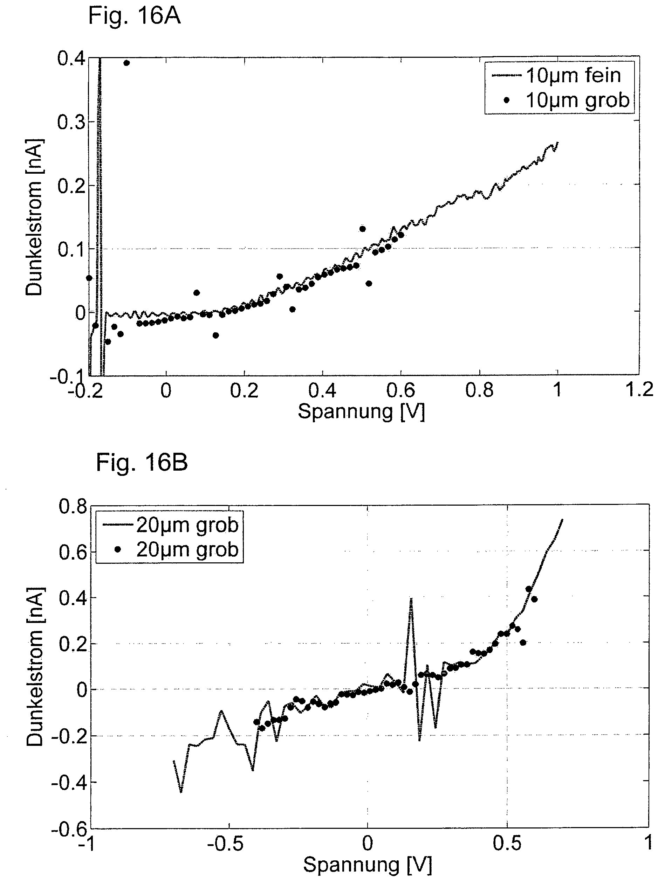

Es wurden die Dunkelströme des plasmonischen Photodetektors mit Längen von 10 $\mu$m und 20 $\mu$m gemessen, welche in Fig. 16 abgebildet sind (Instrumente: Agilent B2900A series, Elektroden on-Chip kontaktiert mit DC-Probes der Firma Cascade Microtech Inc.). Die Messreihen wurden aufgrund der kleinen Signalstärke nahe an der Auflösungsgrenze mit unterschiedlicher Zeitkonstante und Spannungsauflösung durchgeführt, d.h. kurzer Mittelungszeit und geringer Spannungsauflösung (coarse). Entsprechend das Vorgehen bei "fine". Im Vergleich zu bekannten plasmonischen Photodetektoren, wie in M. Casalino et al., Optics Express, Vol. 21 (23), S. 28072-28082 (2013) beschrieben, ist der Dunkelstrom um eine Größenordnung kleiner.

Aufgrund des kleinen Querschnitts ist die RC Zeitkonstante die entscheidende geschwindigkeitsbestimmende Größe. Mit einer angenommenen Kapazität in der Größenordnung von 1 fF/μm Bauteillänge und einer 50 Ω Verbindung zur externen Ansteuerelektronik, konnte eine RC Zeitkonstante von ungefähr 0,25 ps und eine daraus resultierenden Grenzfrequenz (Höchstfrequenz) von 4 THz für ein 5 μm langes Bauteil abgeschätzt werden.

In Anbetracht der vorstehenden Ergebnisse konnte gezeigt werden, dass aufgrund des linearen Anstiegs des Photostroms mit der eintreffenden optischen Energie und dem exponentiellen Anstieg mit photonischer Energie, die Photodetektion im beschriebenen Bauteil auf Grundlage einer internen Photoemission erfolgt. Insbesondere konnte aufgrund der Messdaten die Zwei-Photonen-Absorption ausgeschlossen werden, welche einen parabelförmigen Anstieg des Photostroms mit der eintreffenden optischen Energie gezeigt hätte.

**Bezugszeichenliste**

| | |
|---|---|
| 1 | Oxidschicht |
| 2 | Halbleiterschicht |
| 3 | Substrat |
| 4 | erste Metallschicht |
| 5 | zweite Metallschicht |
| 6 | Resist |
| d | Dicke der Halbleiterschicht |
| $d_B$ | maximale Dicke der Halbleiterschicht |
| 10 | 3-Achsige Piezobühne |
| 11 | Si-Chip mit Metall-Halbleiter-Metall Wellenleitern und angeschlossener Messelektronik |
| 12 | Lichtwellenleiter mit Linse, Brennfleck 5 μm |
| 13 | NIR Laser Quelle |
| 14 | einmodige, optische Glasfaser |
| 15 | Polarisationskontrolle |

**Patentansprüche**

1. Verfahren zur Herstellung eines plasmonischen Bauteils mit einem Metall-Halbleiter-Metall Kontakt, bei welchem eine erste Metallschicht (4) von einer von der ersten Metallschicht (4) verschiedenen zweiten Metallschicht (5) durch eine Halbleiterschicht (2) mit einer Dicke von 100 nm oder weniger getrennt ist, umfassend die folgenden Schritte:

- Bereitstellen einer Halbleiterschicht (2) auf einem Substrat (3);
- Bereitstellen einer Oxidschicht (1) mindestens teilweise auf einer der Oberflächen der Halbleiterschicht (2);
- Aufbringen einer strukturierten Resistschicht (6) mindestens teilweise auf die der Halbleiterschicht (2) gegenüberliegenden Oberfläche der Oxidschicht (1) derart, dass Bereiche mit der Resistschicht (6) und Bereiche ohne Resistschicht entstehen und Bereiche mit der Resistschicht (6) einer Rohform des Metall-Halbleiter-Metall Kontakts entsprechen;
- Entfernen der Oxid- und Halbleiterschicht in Bereichen ohne Resistschicht unter Entstehung von mindestens zwei seitlichen Oberflächen der Halbleiterschicht (2);
- anschließend seitliches Unterätzen der Oxidschicht (1) durch isotropes Ätzen, wodurch im Querschnitt die Kontur des Metall-Halbleiter-Metall Kontakts erzeugt wird; und anschließend
- Aufbringen von mindestens zwei Schichten aus jeweils unterschiedlichen Metallen (4,5) durch gewinkelte Bedampfung auf die seitlichen Oberflächen der Halbleiterschicht (2) unter Bildung des Metall-Halbleiter-Metall Kontakts, wobei die erste Metallschicht (4) nicht in direktem Kontakt mit der zweiten Metallschicht (5) steht,

wobei die erste Metallschicht (4) aus einem Metall, ausgewählt aus der Gruppe, bestehend aus Gold, Silber und Aluminium sowie deren Legierungen, besteht und die zweite Metallschicht (5) aus einem Metall, ausgewählt aus der Gruppe, bestehend aus Titan, Chrom, Kupfer, Zirkonium, Nickel, Palladium, Platin, Zinn, Blei und Bismut sowie deren Legierungen, besteht und wobei die Metallschichten (4,5) derart ausgewählt sind, dass elektromagnetische Wellen überwiegend in der zweiten Metallschicht (5) absorbiert werden und das Metall der zweiten, stark absorbierenden Metallschicht (5) eine im Vergleich zum Metall der ersten Metallschicht (4) geringere Potentialbarriere zur Halbleiterschicht (2) aufweist.

2. Verfahren nach Anspruch 1, wobei das plasmonische Bauteil in Form eines Wellenleiters vorliegt.

3. Verfahren nach Anspruch 1 oder 2, wobei die strukturierte Resistschicht (6) mittels Elektronen- oder Ionenstrahl- oder Laserlithographie aufgebracht wird.

4. Verfahren nach einem der Ansprüche 1 bis 3, wobei die erste Metallschicht (4) mindestens auf einer ersten Oberfläche der Halbleiterschicht (2) aufgetragen wird und die zweite Metallschicht (5) auf der der ersten Oberfläche gegenüberliegenden Oberfläche der Halbleiterschicht (2) aufgetragen wird.

5. Verfahren zur Herstellung eines plasmonischen Photodetektors unter Verwendung des Verfahrens nach einem der Ansprüche 1 bis 4, wobei das plasmonische Bauteil an eine anzulegende Spannung gekoppelt wird.

6. Verfahren nach Anspruch 5, wobei das plasmonische Bauteil an einen photonischen Siliziumwellen-

7. Plasmonisches Bauteil mit einem Metall-Halbleiter-Metall Kontakt, bei welchem eine erste Metallschicht (4) von einer von der ersten Metallschicht (4) verschiedenen zweiten Metallschicht (5) durch eine Halbleiterschicht (2) mit einer Dicke (d) von weniger als 100 nm getrennt ist, wobei die erste Metallschicht (4) nicht in direktem Kontakt mit der zweiten Metallschicht (5) steht,
**dadurch gekennzeichnet, dass** eine Oxidschicht (1), welche eine unterätzte Oxidschicht (1) ist, die erste Metallschicht (4) von der zweiten Metallschicht (5) trennt, wobei die erste Metallschicht (4) aus einem Metall, ausgewählt aus der Gruppe, bestehend aus Gold, Silber und Aluminium sowie deren Legierungen, besteht und die zweite Metallschicht (5) aus einem Metall, ausgewählt aus der Gruppe, bestehend aus Titan, Chrom, Kupfer, Zirkonium, Nickel, Palladium, Platin, Zinn, Blei und Bismut sowie deren Legierungen, besteht und wobei die Metallschichten (4,5) derart ausgewählt sind, dass elektromagnetische Wellen überwiegend in der zweiten Metallschicht (5) absorbiert werden und das Metall der zweiten, stark absorbierenden Metallschicht (5) eine im Vergleich zum Metall der ersten Metallschicht (4) geringere Potentialbarriere zur Halbleiterschicht (2) aufweist.

8. Plasmonisches Bauteil nach Anspruch 7 in Form eines Wellenleiters, bei welchem eine erste Elektrode in Form einer ersten Metallschicht (4) von einer zweiten Elektrode in Form einer von der ersten Metallschicht (4) verschiedenen Metallschicht (5) durch eine Halbleiterschicht (2) mit einer Dicke von weniger als 100 nm getrennt ist, wobei die erste Metallschicht (4) nicht in direktem Kontakt mit der zweiten Metallschicht (5) steht.

9. Plasmonisches Bauteil nach Anspruch 7 oder 8, wobei die Länge des Metall-Halbleiter-Metall Kontakts 0,5 $\mu$m bis 100 $\mu$m beträgt.

10. Plasmonischer Photodetektor, umfassend das plasmonische Bauteil nach einem der Ansprüche 7 bis 9, wobei die Metallschichten Elektroden darstellen, an welchen die Photodetektion stattfindet.

11. Plasmonischer Photodetektor nach Anspruch 10 mit einer photoaktiven Elektrode und einer Gegenelektrode.

12. Plasmonischer Photodetektor nach Anspruch 10 oder 11, wobei das plasmonische Bauteil direkt an einen photonischen Siliziumwellenleiter ankoppelt.

13. Verwendung des plasmonischen Bauteils nach einem der Ansprüche 7 bis 9 als Verstärker, Elektro-Optischer Wandler oder Phasenschieber.

14. Verwendung des plasmonischen Photodetektors nach einem der Ansprüche 10 bis 12 zur Photodetektion im Infrarot- und sichtbaren Bereich des Spektrums in optischen Chip-Chip-Verbindungen und On-Chip Verbindungen, sowie in der Freistrahloptik.

15. Verwendung des plasmonischen Bauteils und/oder Photodetektors nach einem der Ansprüche 7 bis 12 in der Photovoltaik.

**Claims**

1. A method for producing a plasmonic component with a metal-semiconductor-metal contact, in which a first metal layer (4) is separated from a second metal layer (5) different from the first metal layer (4) by a semiconductor layer (2) having a thickness of 100 nm or less, comprising the following steps:

    - providing a semiconductor layer (2) on a substrate (3);
    - providing an oxide layer (1) at least partially on one of the surfaces of the semiconductor layer (2);
    - applying a structured resist layer (6) at least partially to the surface of the oxide layer (1) opposite the semiconductor layer (2) in such a way that areas with the resist layer (6) and areas without a resist layer are formed and areas with the resist layer (6) correspond to a raw form of the metal-semiconductor-metal contact;
    - removing the oxide and semiconductor layers in areas without a resist layer, thus forming at least two lateral surfaces of the semiconductor layer (2);
    - subsequently laterally undercutting the oxide layer (1) by isotropic etching, whereby the contour of the metal-semiconductor-metal contact is generated in cross section; and subsequently
    - applying at least two layers of different metals (4, 5) by angled vapor deposition to the lateral surfaces of the semiconductor layer (2), thus forming the metal-semiconductor-metal contact, wherein the first metal layer (4) is not in direct contact with the second metal layer (5), wherein the first metal layer (4) consists of a metal selected from the group consisting of gold, silver and aluminum and their alloys, and the second metal layer (5) consists of a metal selected from the group consisting of titanium, chromium, copper, zirconium, nickel, palladium, platinum, tin, lead and bismuth and their alloys, and wherein the metal layers (4, 5) are selected such that electromagnetic waves are predominantly absorbed in the second metal layer (5) and the metal of the second, highly absorbent metal layer (5) has a lower potential barrier to the semiconductor layer (2) than the metal of the first metal layer (4).

2. The method according to claim 1, wherein the plasmonic component is in the form of a waveguide.

3. The method according to claim 1 or 2, wherein the structured resist layer (6) is applied by means of electron or ion beam or laser lithography.

4. The method according to one of claims 1 to 3, wherein the first metal layer (4) is applied to at least a first surface of the semiconductor layer (2) and the second metal layer (5) is applied to the surface of the semiconductor layer (2) opposite the first surface.

5. A method for producing a plasmonic photodetector using the method according to one of claims 1 to 4, wherein the plasmonic component is coupled to a voltage to be applied.

6. The method according to claim 5, wherein the plasmonic component is coupled to a photonic silicon waveguide.

7. A plasmonic component with a metal-semiconductor-metal contact, in which a first metal layer (4) is separated from a second metal layer (5) different from the first metal layer (4) by a semiconductor layer (2) having a thickness (d) of 100 nm or less, the first metal layer (4) not being in direct contact with the second metal layer (5), **characterized in that** an oxide layer (1), which is an undercut oxide layer (1), separates the first metal layer (4) from the second metal layer (5), wherein the first metal layer (4) consists of a metal selected from the group consisting of gold, silver and aluminum and their alloys, and the second metal layer (5) consists of a metal selected from the group consisting of titanium, chromium, copper, zirconium, nickel, palladium, platinum, tin, lead and bismuth and their alloys, and wherein the metal layers (4, 5) are selected such that electromagnetic waves are predominantly absorbed in the second metal layer (5) and the metal of the second, highly absorbent metal layer (5) has a lower potential barrier to the semiconductor layer (2) than the metal of the first metal layer (4).

8. The plasmonic component according to claim 7 in the form of a waveguide, in which a first electrode in the form of a first metal layer (4) is separated from a second electrode in the form of a metal layer (5) different from the first metal layer (4) by a semiconductor layer (2) having a thickness of less than 100 nm, the first metal layer (4) not being in direct contact with the second metal layer (5).

9. The plasmonic component according to claim 7 or 8, wherein the length of the metal-semiconductor-metal contact is 0.5 $\mu$m to 100 $\mu$m.

10. A plasmonic photodetector, comprising the plasmonic component according to one of claims 7 to 9, wherein the metal layers represent electrodes on which the photodetection takes place.

11. The plasmonic photodetector according to claim 10 with a photoactive electrode and a counter electrode.

12. The plasmonic photodetector according to claim 10 or 11, wherein the plasmonic component couples directly to a photonic silicon waveguide.

13. A use of the plasmonic component according to one of claims 7 to 9 as an amplifier, electro-optical converter or a phase shifter.

14. The use of the plasmonic photodetector according to one of claims 10 to 12 for photodetection in the infrared and visible ranges of the spectrum in optical chip-chip connections and on-chip connections, as well as in free-beam optics.

15. The use of the plasmonic component and/or photodetector according to one of claims 7 to 12 in photovoltaics.

**Revendications**

1. Procédé de fabrication d'un module plasmonique muni d'un contact métal-semiconducteur-métal, dans lequel une première couche métallique (4) est séparée d'une deuxième couche métallique (5), différente de la première couche métallique (4), par une couche de semiconducteur (2) présentant une épaisseur de 100 nm ou moins, comprenant les étapes suivantes:

- fourniture d'une couche de semiconducteur (2) sur un substrat (3);
- fourniture d'une couche d'oxyde (1) au moins partiellement sur l'une des surfaces de la couche de semiconducteur (2);
- application d'une couche de résist (6) structurée au moins partiellement sur la surface de la couche d'oxyde (1) opposée à la couche de semiconducteur (2) de telle manière que des zones avec une couche de résist (6) et des zones sans couche de résist apparaissent et des zones avec une couche de résist (6) correspondent à la forme tubulaire du contact métal-semiconducteur-métal;
- élimination de la couche d'oxyde et de celle de semiconducteur dans les zones sans couche de résist avec apparition d'au moins deux surfaces latérales de la couche de semiconducteur (2);

- ensuite gravure sous-jacente latérale de la couche d'oxyde (1) par gravure isotrope, ce qui produit en section transversale, le contour du contact métal-semiconducteur-métal; et ensuite

- application d'au moins deux couches constituées chacune de métaux différents (4,5) par métallisation sous vide coudée sur les surfaces latérales de la couche de semiconducteur (2) avec formation du contact métal-semiconducteur-métal, la première couche métallique (4) n'étant pas en contact direct avec la deuxième couche métallique (5), la première couche métallique (4) étant confectionnée d'un métal sélectionné parmi le groupe constitué par l'or, l'argent et l'aluminium, ainsi que leurs alliages, et la deuxième couche métallique (5) étant confectionnée d'un métal sélectionné parmi le groupe constitué par le titane, le chrome, le cuivre, le zirconium, le nickel, lepalladium, leplatine, l'étain, le plomb et le bismuth ainsi que leurs alliages, et les couches métalliques (4,5) étant sélectionnées de manière que les ondes électromagnétiques sont absorbées en grande partie dans la deuxième couche métallique (5) et le métal de la deuxième couche métallique (5) hyperabsorbante présente, comparé au métal de la première couche métallique (4) une barrière de potentiel plus faibles avec la couche de semiconducteur (2).

2. Procédé selon la revendication 1, dans lequel le module plasmonique existe sous la forme d'un guide d'onde.

3. Procédé selon la revendication 1 ou 2, dans lequel la couche de résist (6) structurée est appliquée par lithographie à faisceau d'électrons, ou à faisceau d'ions ou laser.

4. Procédé selon l'une des revendications 1 à 3, dans lequel la première couche métallique (4) est appliquée au moins sur la première surface de la couche de semiconducteur (2) et la deuxième couche métallique (5) est appliquée sur la surface de la couche de semiconducteur (22) opposée à la première surface.

5. Procédé de fabrication d'un photodétecteur plasmonique par l'utilisation du procédé selon l'une des revendications 1 à 4, dans lequel le module plasmonique est couplé à une tension à établir.

6. Procédé selon la revendication 5, dans lequel le module plasmonique est couplé à un guide d'onde de silicium photonique.

7. Module plasmonique muni d'un contact métal-semiconducteur-métal, dans lequel la première couche métallique (4) est séparée de la deuxième couche métallique (5) différente de la première couche métallique (4) par une couche de semiconducteur (2) d'une épaisseur (d) inférieure à 100 nm, la première couche métallique (4) n'étant pas en contact direct avec la deuxième couche métallique (5), **caractérisé en ce qu'**une couche d'oxyde (1), qui est une couche d'oxyde (1) gravée de manière sous-jacente, sépare la première couche métallique (4) de la deuxième couche métallique (5), la première couche métallique (4) étant confectionnée d'un métal sélectionné parmi le groupe constitué par l'or, l'argent et l'aluminium ainsi que leurs alliages, et la deuxième couche métallique (5) est confectionnée d'un métal sélectionné parmi le groupe constitué par le titane, le chrome, le cuivre, le zirconium, le nickel, le palladium, le platine, l'étain, le plomb et le bismuth ainsi que leurs alliages, et les couches métalliques (4,5) étant sélectionnées de manière que les ondes électromagnétiques sont absorbées en grande partie dans la deuxième couche métallique (5) et le métal de la deuxième couche métallique (5) hyperabsorbante présenteune barrière de potentiel plus faible par rapport à la couche de semiconducteur (2), comparé au métal de la première couche métallique (4).

8. Module plasmonique selon la revendication 7 en forme de guide d'onde, dans lequel une première électrode, sous la forme d'une première couche métallique (4) est séparée d'une deuxième électrode sous la forme d'une couche métallique (5) différente de la première couche métallique (4), par une couche de semiconducteur (2) présentant une épaisseur inférieure à 100 nm, la première couche métallique (4) n'étant pas en contact direct avec la deuxième couche métallique (5).

9. Module plasmonique selon la revendication 7 ou 8, dans lequel la longueur du contact métal-semiconducteur-métal va de 0,5 $\mu$m à 100 $\mu$m.

10. Photodétecteur plasmonique, comprenant le module plasmonique selon l'une des revendications 7 à 9, dans lequel les couches métalliques représentent des électrodes sur lesquelles a lieu la photodétection.

11. Photodétecteur plasmonique selon la revendication 10 muni d'une électrode photoactive et d'une contre-électrode.

12. Photodétecteur plasmonique selon la revendication 10 ou 11, dans lequel le module plasmonique est directement couplé à un guide d'onde de silicium photonique.

**13.** Utilisation du module plasmonique selon l'une des revendications 7 à 9 comme amplificateur, transducteur électro-optique ou déphaseur.

**14.** Utilisation du photodétecteur plasmonique selon l'une des revendications 10 à 12 pour la photodétection dans la région infrarouge et visible du spectre dans des connexions optiques *chip-chip* et *on-chip,* ainsi que dans l'optique à jet libre.

**15.** Utilisation du module plasmonique et/ou du photodétecteur selon l'une des revendications 7 à 12 dans les technologies photovoltaïques.

## Fig. 1

## Fig. 2

## Fig. 3

Aufsicht

## Fig. 4

Fig. 5

Fig. 6

Fig. 7A

Fig. 7B

# Fig. 8

A)

B)

C)

# Fig. 8

D)

E)

Au

Au

Au

Ti

4

5

Fig. 9

A)

B)

Fig. 10

Fig. 11

## Fig. 12

## Fig. 13

Fig. 14

Fig. 15

Fig. 16A

Fig. 16B

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2012280345 A1

**In der Beschreibung aufgeführte Nicht-Patentliteratur**

- **M. W. KNIGHT et al.** *Science,* 2011, vol. 332 (6030), 702-704
- **M. CASALINO et al.** *Optics Express,* 2013, vol. 21 (23), 28072-28082
- **CHEN.** Current Transport and its Effect on the Schottky-Barrier Height in a typical System: Gold on Silicon. *Solid-State Electronics,* 1993, vol. 36 (7), 949-954
- Titanium-Silicon Schottky Barrier Diodes. **A.M. COWLEY.** Solid-State Electronics. Pergamon, 1970, vol. 12, 403-414